# EUROPÄISCHE PATENTSCHRIFT

(11) **EP 1 502 293 B1**
(45) Veröffentlichungstag und Bekanntmachung des Hinweises auf die Patenterteilung: **09.09.2015**
(21) Anmeldenummer: 03746159.7
(22) Anmeldetag: 15.04.2003
(51) Int. Cl.: C23C 14/10, H01L 21/02, H01L 23/10, H01L 23/31, H01L 51/52

(54) **VERFAHREN ZUR HERSTELLUNG STRUKTURIERTER SCHICHTEN AUF SUBSTRATEN**
METHOD FOR THE PRODUCTION OF STRUCTURED LAYERS ON SUBSTRATES
PROCEDE DE FABRICATION DE COUCHES STRUCTUREES SUR DES SUBSTRATS

(30) Priorität: 15.04.2002 DE 20205830 U; 23.05.2002 DE 10222958; 23.05.2002 DE 10222964; 23.05.2002 DE 10222609; 13.11.2002 DE 10252787; 16.01.2003 DE 10301559
(43) Veröffentlichungstag der Anmeldung: 02.02.2005
(73) Patentinhaber: Schott AG, 55122 Mainz (DE)
(72) Erfinder: LEIB, Jürgen, 85345 Freising (DE); BIECK, Florian, 55118 Mainz (DE); MUND, Dietrich, 84101 Obersüssbach (DE)
(74) Vertreter: Herden, Andreas F.
(86) Internationale Anmeldenummer: PCT/EP2003/003884
(87) Internationale Veröffentlichungsnummer: WO 2003/088340

(56) Entgegenhaltungen:
- US-A- 4 506 435
- US-A1- 2001 055 864
- PATENT ABSTRACTS OF JAPAN Bd. 008, Nr. 014 (P-249), 21. Januar 1984 (1984-01-21) & JP 58 172679 A (FUJI SHASHIN FILM KK), 11. Oktober 1983 (1983-10-11)
- PATENT ABSTRACTS OF JAPAN Bd. 2000, Nr. 12, 3. Januar 2001 (2001-01-03) & JP 2000 241985 A (PIONEER ELECTRONIC CORP), 8. September 2000 (2000-09-08)
- ANONYMOUS: "Balanced Resistance Magnetoresistive Head Compensated against Thermal and Piezoresistive Effects. April 1975." IBM TECHNICAL DISCLOSURE BULLETIN, Bd. 17, Nr. 11, 1. April 1975 (1975-04-01), Seiten 3478-3480, XP002264775 New York, US

## Beschreibung

Die Erfindung nach Anspruch 1 betrifft ein Verfahren zur Herstellung strukturierter Schichten auf Substraten, insbesondere zur Herstellung strukturierter Schichten mit glasartiger Struktur auf Oberflächen von Substraten.

Für die Fertigung insbesondere von integrierten HalbleiterBauelementen, optoelektronischen oder anderen Sensor- oder Emitter-Bauelementen kann es notwendig oder von Vorteil sein, genau strukturierte Passivierungsschichten zu erzeugen. Beispielsweise kann es notwendig sein, an manchen Stellen Öffnungen in eine Verkapselung einzufügen, um etwa elektrische Kontaktierungen des verpackten Teils zu ermöglichen. Insbesondere wird Glas für eine Vielzahl von Anwendungen unter anderem wegen seiner hervorragenden Passivierungseigenschaften geschätzt und eingesetzt. Die Permeabilität für Gasmoleküle aus der Luft ist beispielsweise um Größenordungen kleiner als die von Kunststoffen, die sonst für die Verpackung und Kapselung beispielsweise von Halbleiterbauelementen eingesetzt werden, so daß sich ein Material mit glasartiger Struktur, wie insbesondere ein Glas günstig auf die Lebensdauer der Bauelemente auswirken kann. Gläser bieten darüber hinaus auch einen hervorragenden Schutz gegen Wasser, Wasserdampf und insbesondere auch gegen aggressive Stoffe, wie Säuren und Basen.

Die genaue Bearbeitung von Glasschichten ist jedoch problembehaftet. Beispielsweise ist es bekannt, photostrukturierbare Gläser, wie beispielsweise FOTURAN zu verwenden. Derartige Gläser sind jedoch außerordentlich teuer. Weiterhin besteht die Möglichkeit, Gläser nass- oder trockenchemisch zu ätzen. Jedoch lassen sich besonders bei Gläsern hier nur geringe Ätzraten erreichen, so daß auch ein solches Verfahren langsam und dementsprechend für eine Massenproduktion zu teuer ist. Zudem kann das nachträgliche Ätzen auch das verkapselte Teil beschädigen oder zerstören. Auch mit Laserbearbeitung lassen sich auf Gläsern genaue Strukturen herstellen, jedoch ist auch diese Technik sehr langsam und für eine Massenproduktion zu teuer. Ferner sind verschiedene mechanische Bearbeitungsverfahren bekannt, die aber im allgemeinen nicht die mit anderen Verfahren erreichbare Genauigkeit ermöglichen.

Die Erfindung hat sich daher die Aufgabe gestellt, eine exakte Strukturierung von Beschichtungen, welche Glas oder ein Material mit glasartiger Struktur aufweisen, bereitzustellen, welche schnell und kostengünstig durchführbar ist und dennoch die Herstellung exakt positionierter Strukturen erlaubt.

Diese Aufgabe wird bereits in höchst überraschender Weise durch ein Verfahren gemäß den unabhängigen Ansprüchen gelöst. Vorteilhafte Weiterbildungen sind Gegenstand der jeweiligen Unteransprüche.

Das Verfahren zur strukturierten Beschichtung von Substraten mit zumindest einer zu beschichtenden Oberfläche umfasst dazu die Schritte:
- Herstellen zumindest einer negativ strukturierten ersten Beschichtung auf der zumindest einen Oberfläche,
- Abscheiden einer zweiten Schicht, die ein Material mit glasartiger Struktur aufweist, auf die mit der ersten Beschichtung versehene Oberfläche,
- zumindest teilweises Entfernen der ersten Beschichtung.

Das Verfahren basiert also darauf, eine Negativform der Strukturen, die erzeugt werden sollen, in Form einer strukturierten ersten Beschichtung aufzubringen. Durch Abscheiden der zweiten Schicht, die ein Material mit glasartiger Struktur aufweist auf der mit der ersten, strukturierten Schicht beschichteten Oberfläche des Substrats werden dann die positiven Strukturen in der zweiten Schicht erzeugt. In einem nachfolgenden Schritt wird dann die erste Beschichtung zumindest teilweise entfernt, so dass positive Strukturen stehen bleiben, die von der zweiten Schicht gebildet werden. Als positive und negative Strukturen werden dabei im Sinne des angegebenen Verfahrens allgemein zueinander zumindest teilweise komplementäre Strukturen bezeichnet. Dies bedeutet auch insbesondere, daß die zumindest eine zweite Beschichtung sowohl erhabene, als auch vertiefte Strukturen aufweisen kann. Die zweite Schicht, die ein Material mit glasartiger Struktur aufweist, umfaßt ein PIAD Aufdampfglas.

Schichten mit glasartiger Struktur sind bekannt für ihre außerordentlich gute Barrierewirkung. Als Material mit glasartiger Struktur wird in diesem Zusammenhang ein Material mit fehlender Fernordnung der dieses Material mit glasartiger Struktur konstituierenden Elemente und/oder Stoffe und gleichzeitig vorhandener Nahordnung der Stoffe und/oder Elemente verstanden. Gegenüber nicht glasartigen, also im wesentlichen mikrokristallinen, polykristallinen oder kristallinen Schichten zeichnen sich die mittels des Verfahrens aufgebrachten Schichten unter anderem aufgrund der amorphen Struktur durch das weitgehende Fehlen von Korngrenzen aus. Die Zusammensetzung der Schicht, welche ein Material mit glasartiger Struktur aufweist, kann vorteilhaft so gewählt werden, daß diese an das Material der Oberfläche des Substrats angepaßt ist.

Bezüglich der Barriereeigenschaften von Aufdampfglas für die Verkapselung von Bauelementen und anderen Substraten wird auch auf die Anmeldungen
DE 202 05 830.1, eingereicht am 15.04.2002,
DE 102 22 964.3, eingereicht am 23.05.2002;
DE 102 22 609.1, eingereicht am 23.05.2002;
DE 102 22 958.9, eingereicht am 23.05.2002;
DE 102 52 787.3, eingereicht am 13.11.2002;
DE 103 01 559.0, eingereicht am 16.01.2003;
desselben Anmelders verwiesen, deren Offenbarungsgehalt hiermit ausdrücklich durch Referenz inkorporiert wird.

US2001/0055864A1 offenbart das Herstellen von MEMS Bauelementen. Hinsichtlich der Barriereeigenschaften von Aufdampfglasschichten haben Messungen gezeigt, daß bei Schichtdicken der Aufdampfglasschicht im Bereich von 8 µm bis 18 µm Helium-Leckraten von kleiner als 10⁻⁷ mbar l s⁻¹ oder kleiner als 10⁻⁸ mbar l s⁻¹ sicher erreicht werden. Die Messungen haben bei Schichten mit einer Schichtdicke von 8 µm und 18 µm sogar Helium-Leckraten zwischen 0 und 2×10⁻⁹ mbar l s⁻¹ ergeben, wobei diese oberen Grenzwerte bereits im wesentlichen durch die Meßungenauigkeit der durchgeführten Versuche beeinflußt sind.

Als Substrat kann für das Verfahren sowohl ein Bauelement selbst, als auch ein Substrat dienen, welches anschließend beispielsweise mit einem Bauelement verbunden wird.

Besonders vorteilhaft kann der Schritt des Herstellens einer negativ strukturierten ersten Beschichtung auf der Oberfläche des Substrats den Schritt des Freilegens von Bereichen der zumindest einen zu beschichtenden Oberfläche umfassen. Auf diese Weise kommt die zweite Schicht, die ein Material mit glasartiger Struktur aufweist, beim Abscheiden direkt mit der zu beschichtenden Oberfläche des Bauteils in Kontakt und zwischen der Oberfläche und der Schicht wird eine innige, direkte Verbindung geschaffen.

Bevorzugt wird das Verfahren im Waferverbund durchgeführt, wobei das Substrat ein Wafer oder Bestandteil eines Wafers ist. Die Durchführung des Verfahrens im Waferverbund ermöglicht eine besonders rationelle Herstellung derartiger beschichteter Substrate. Insbesondere kann das Verfahren so auch zum Verpacken von Bauteilen im Waferverbund verwendet werden, beziehungsweise Teil einer "Wafer-Level Packaging" Prozedur sein. Dabei können Bauelemente als Dies des Substrats, beziehungsweise des Wafers vorhanden sein. Ebenso kann auch ein Substrat mit einem Wafer mit Dies im Waferverbund zusammengefügt werden.

Für das Abscheiden der zweiten Schicht, die ein Material mit glasartiger Struktur aufweist, sind verschiedene Verfahren geeignet. Gemäß einer bevorzugten Weiterbildung des Verfahrens umfaßt der Schritt des Abscheidens einer zweiten Schicht, die ein Material mit glasartiger Struktur aufweist, den Schritt des Abscheidens einer Schicht durch Aufdampfen.

Insbesondere bietet sich hierbei an, Material durch Elektronenstrahlverdampfung zu verdampfen. Vorteilhaft bei der Elektronenstrahlverdampfung ist unter anderem, daß sich die durch den Elektronenstrahl übertragene Leistung auf einem verhältnismäßig kleinen Gebiet durch Fokussierung des Strahls konzentrieren läßt. Damit können lokal auf dem Target des Verdampfers hohe Temperaturen erreicht werden, so daß sich hohe Flüsse mit relativ kleinen Leistungen erreichen lassen. Dies senkt gleichzeitig auch die Wärmebelastung durch Absorption von Wärmestrahlung, der das Substrat ausgesetzt wird.

Vorteilhaft kann der Schritt des Aufdampfens einer Schicht, die ein Material mit glasartiger Struktur aufweist, auch den Schritt des Verdampfens von Aufdampfmaterial, welches auf der Oberfläche abgeschieden ein Material mit glasartiger Struktur bildet, aus einer einzelnen Quelle umfassen. Dadurch, daß das Material aus einer einzelnen Quelle abgeschieden wird, läßt sich eine hohe Reproduzierbarkeit der Schichten erreichen. Veränderungen der Schichtstöchiometrie durch Leistungsschwankungen mehrerer Quellen können auf diese Weise vermieden werden.

Die Schicht kann auch ebenso aus zumindest zwei Quellen durch Coverdampfung abgeschieden werden. Dies ist beispielsweise vorteilhaft, um die Schichtzusammensetzung in einer Richtung senkrecht zur Oberfläche variieren zu können. Auf diese Weise können die Materialeigenschaften, wie beispielsweise der Brechungsindex oder auch der Temperaturkoeffizient in Richtung senkrecht zur Oberfläche variiert werden. Eine Variation der Zusammensetzung der Schicht ist selbstverständlich auch mit anderen Abscheideverfahren, sogar mit einer einzelnen Aufdampfquelle, etwa durch Variation der Heizleistung möglich. Der Schritt des Abscheidens einer zweiten Schicht, die ein Material mit glasartiger Struktur aufweist, kann daher allgemein mit Vorteil den Schritt des Variierens der Zusammensetzung des abscheidenden Materials während des Abscheidens, oder den Schritt des Abscheidens einer Schicht mit entlang einer Richtung senkrecht zur Oberfläche variierender Zusammensetzung umfassen. Vorteilhaft kann das Abscheiden einer Schicht durch Aufdampfen außerdem den Schritt des Plasma-Ionenunterstützten Aufdampfens (PIAD) umfassen. Dabei wird zusätzlich ein Ionenstrahl auf das zu beschichtende Substrat gerichtet. Der Ionenstrahl kann mittels einer Plasmaquelle, beispielsweise durch Ionisation eines geeigneten Gases erzeugt werden. Durch das Plasma erfolgt eine zusätzliche Verdichtung der Schicht sowie die Ablösung lose haftender Partikel auf der Substratoberfläche. Dies führt zu besonders dichten und defektarmen abgeschiedenen Schichten.

Zum Beschichten mit einer Schicht mit glasartiger Struktur sind neben dem Aufdampfen auch andere Verfahren zweckmäßig einsetzbar. Beispielsweise kann der Schritt des Abscheidens einer Schicht mit glasartiger Struktur den Schritt des Aufsputterns einer Schicht mit glasartiger Struktur umfassen. Durch Aufsputtern lassen sich unter anderem auch Schichten mit glasartiger Struktur erzeugen, die erst bei hohen Temperaturen schmelzende Materialien umfassen und sich somit nicht für eine Verdampfung eignen.

Der Schritt des Abscheidens einer Schicht mit glasartiger Struktur kann weiterhin mit Vorteil den Schritt des Abscheidens einer Schicht mit glasartiger Struktur mittels chemischer Dampfphasenabscheidung (CVD) umfassen. Beispielsweise können auf diese Weise ebenfalls Materialien abgeschieden werden, die ansonsten für eine Verdampfung einen zu niedrigen Dampfdruck oder zu hohen Schmelzpunkt aufweisen. Da bei der CVD, insbesondere der plasmainduzierten chemischen Dampfphasenabscheidung (PICVD) die Synthese des abgeschiedenen Materials erst auf der Oberfläche stattfindet, können so etwa auch Schichten erzeugt werden, die sich nur schwer aufdampfen oder aufsputtern lassen. Beispielsweise kann es sich dabei um Stoffe handeln, die Moleküle mit hohem Molekulargewicht aufweisen, welche beim Verdampfen oder Absputtern von einem Target zerstört würden.

Ein besonderer Vorzug des Verfahrens ist, daß das Aufbringen einer Schicht mit glasartiger Struktur durch Abscheiden mit einer im allgemeinen sehr niedrigen Aufheizung des Substrats einhergeht, beispielsweise im Vergleich zum Aufschmelzen einer solchen Schicht. Dies gilt für das Abscheiden durch Aufdampfen ebenso wie für das Abscheiden durch Aufsputtern. Auch bei CVD-Abscheidung kann, beispielsweise bei gepulster Plasmaanregung, beziehungsweise PICVD, die Aufheizung gering gehalten werden. Aufgrund dessen ergeben sich auch nur geringe Temperaturspannungen nach dem Abscheiden. Auf diese Weise wird es daher beispielsweise möglich, auch Schichten mit glasartiger Struktur direkt mit Substraten zu verbinden, die einen zur Schicht stark unterschiedlichen Temperaturausdehnungskoeffizienten besitzen.

Besonders geeignet für die Herstellung der strukturierten Beschichtung des Bauteils sind Schichten mit glasartiger Struktur, die ein zumindest binäres Stoffsystem umfassen. Derartige Schichten zeichnen sich im allgemeinen durch besonders niedrige Permeabilitätsraten aus, da sie, anders als beispielsweise Quarzgläser kaum Neigung zur Bildung kristalliner Bereiche zeigen. Solche zumindest binären Stoffsysteme können sich beispielsweise aus mindestens zwei Metalloxiden oder Siliziumdioxid und einem oder mehreren Metalloxiden zusammensetzen.

Das Abscheiden der Schicht mit glasartiger Struktur kann außerdem in vorteilhafter Ausgestaltung des Verfahrens auch den Schritt des Coabscheidens eines organischen Materials umfassen. Das Coabscheiden, beziehungsweise die gleichzeitige Abscheidung des organischen Materials zusammen mit dem Schichtmaterial, welches eine Schicht mit glasartiger Struktur bildet, kann beispielsweise durch Coverdampfung oder Abscheiden aus der Restgasatmosphäre geschehen. Die Moleküle des organischen Materials werden dabei in die Schicht mit glasartiger Struktur mit eingebaut. Das organische Material kann die Schichteigenschaften in vielfältiger Weise positiv beeinflussen. Beispielhaft sei dazu eine höhere Flexibilität der Schicht gegen mechanische Beanspruchung, die Anpassung optischer und mechanischer Eigenschaften, die Verbesserung der Schichthaftung, indem etwa die Schicht als Gradientenschicht mit Veränderung des organischen Anteils abgeschieden wird, die Änderung der Packungsdichte und des Schichtgefüges, sowie die Beeinflussung der chemischen Eigenschaften der Schicht, insbesondere durch Zusatz von hydrophoben Materialien oder Gettermaterialien genannt.

Der Schritt des Herstellens einer negativ strukturierten ersten Beschichtung kann vorteilhaft den Schritt des Belackens, insbesondere des Belackens mittels Spin-Coating und/oder Aufsprühen und/oder der Elektrodeposition einer ersten Beschichtung umfassen. Diese Techniken erlauben unter anderem die Herstellung von Beschichtungen mit homogener Dicke. Die Belackung kann zur Herstellung besonderer Strukturierungen außerdem auch in mehreren Schritten erfolgen.

Ebenso kann der Schritt des Herstellens einer negativ strukturierten ersten Beschichtung auch den Schritt des Aufbringens einer Photoresist-Folie, insbesondere für eine nachfolgende Photostrukturierung der Folie auf dem Bauteil umfassen. Das Aufbringen der Folie benötigt beispielsweise keine langen Trocknungszeiten, so daß eine schnelle Weiterverarbeitung erfolgen kann.

In besonders vorteilhafter Weise kann das Verfahren auch verfeinert werden, indem der Schritt des Herstellens einer negativ strukturierten ersten Beschichtung den Schritt des strukturierten Aufdruckens einer ersten Beschichtung umfaßt. Drucktechniken können besonders kostengünstig bei gleichzeitig guter Genauigkeit eingesetzt werden, um eine strukturierte Belackung herzustellen. Beispielsweise kann die Beschichtung mittels Siebdruck oder Tintenstrahldruck hergestellt werden. Solche Drucktechniken lassen sich selbstverständlich auch mit anderen Verfahren kombinieren. Die erste Beschichtung kann ferner auch durch Prägen strukturiert werden. Die Prägung von Strukturen stellt, ebenso wie eine strukturierte Belackung eine schnelle und kostengünstige Methode für die Strukturierung der Beschichtung dar.

Der Schritt des Herstellens einer negativ strukturierten ersten Beschichtung kann außerdem den Schritt des lithographischen Strukturierens der ersten Beschichtung umfassen. Lithographische Strukturierung wird in vielfältiger Weise beispielsweise in der Halbleiterfertigung eingesetzt. Diese Strukturierungstechnik wird vielfach eingesetzt und ist daher weit entwickelt, so daß sich hohe Genauigkeiten der Strukturen bei gleichzeitig hohem Durchsatz erreichen lassen. Dieses Verfahren kann unter anderem auch mit Siebdruck kombiniert werden. So lassen sich gröbere Strukturen, wie etwa die Umrisse der Bauteile auf einem Wafer durch Aufdrucken eines Photolacks strukturieren und die Feinstruktur dann lithographisch erzeugen. Diese Weiterbildung des Verfahrens vereint Vorteile der Lithographie mit denen der Glasstrukturierung.

Außerdem kann die lithographische Strukturierung auch den Schritt des lithographischen Graustufenstrukturierens umfassen. Mittels Graustufenstrukturierung lassen sich in der ersten Beschichtung Strukturen mit relativ zur Senkrechten der Oberfläche geneigten Seitenwänden herstellen. Entsprechend weist dann die zweite Schicht Strukturen mit überhängenden Seitenwänden auf.

Allgemein können für die erste, strukturierte Beschichtung photostrukturierbare Materialien, wie insbesondere Photolack verwendet werden, da sich durch Belichtung und Entwicklung der Schicht sehr feine und exakt positionierte Strukturen erzeugen lassen.

Auch für das zumindest teilweise Entfernen der ersten Beschichtung sind, auch abhängig vom Material der Beschichtung, verschiedene Verfahren geeignet. Beispielsweise kann die Beschichtung in einem passenden Lösungsmittel aufgelöst werden.

Ebenso kann das Entfernen der ersten Beschichtung auch nasschemisch und/oder trockenchemisch, insbesondere durch Verbrennen der ersten Beschichtung in einem oxidierenden Plasma erfolgen. Allgemein kann eine chemische Reaktion, wie ein Ätzen oder Verbrennen des Materials der ersten Beschichtung vorteilhaft sein, um auch in schlecht zugänglichen Bereichen auf der Oberfläche des Bauteils, beispielsweise in mit dem Verfahren herstellbaren Gräben oder Kanälen, die Beschichtung zu beseitigen.

Zur Herstellung der positiv strukturierten zweiten Beschichtung kann der Schritt des zumindest teilweisen Entfernens der ersten Beschichtung vorteilhaft den Schritt des Abhebens von Bereichen der zumindest einen zweiten Schicht umfassen. Dabei werden die Bereiche der zweiten Schicht, welche die erste Beschichtung bedecken, beim Entfernen der ersten Beschichtung abgehoben und so entfernt. Diese Variante des Verfahrens ist insbesondere dann sinnvoll, wenn die zweite Schicht die erste Beschichtung nicht vollständig bedeckt.

Eine bevorzugte Variante des Verfahrens, die auch bei vollständiger Bedeckung der ersten Beschichtung durch die zweite Schicht anwendbar ist, sieht als zusätzlichen Verfahrensschritt das zumindest teilweise Freilegen der ersten Beschichtung vor, so dass diese erste Schicht nicht mehr hermetisch von der zweiten Schicht abgedeckt wird. Auf diese Weise wird ein äußerer Zugriff auf die erste Beschichtung ermöglicht.

Um für das nachfolgende Entfernen der ersten Beschichtung einen Zugang zu schaffen, ist es von Vorteil, wenn der Schritt des zumindest teilweisen Freilegens der ersten Beschichtung den Schritt des Planarisierens der beschichteten Oberfläche umfaßt. Dabei wird die beschichtete Oberfläche des Bauteils so weit planarisiert, bis die Schicht mit glasartiger Struktur an den Stellen, an welchen sich Strukturen der ersten, strukturierten Beschichtung befinden, entfernt ist.

Das teilweise Abtragen der Schicht mit glasartiger Struktur, beziehungsweise das zumindest teilweise Freilegen der ersten Beschichtung, kann zweckmäßig durch mechanisches Abtragen, insbesondere mittels Schleifen und/oder Läppen und/oder Polieren erfolgen.

Das Verfahren kann zusätzlich noch den Schritt des Nachbehandelns der positiv strukturierten zweiten Schicht umfassen. Das Nachbehandeln kann beispielsweise dazu dienen, Kanten der Strukturen zu verrunden. Geeignete Nachbehandlungsschritte sind dabei insbesondere nasschemischer und/oder trockenchemischer und/oder thermischer Reflow. Auch durch Dotierung können die Strukturen nachbehandelt werden, um beispielsweise optische oder elektrische Eigenschaften der Strukturen zu verändern.

Bei dem Verfahren können besonders vorteilhaft die Schritte des Herstellens einer negativ strukturierten ersten Beschichtung auf die zumindest eine Oberfläche und des Abscheidens zumindest einer zweiten Schicht mit glasartiger Struktur auf die mit der ersten Beschichtung versehene Oberfläche auch mehrfach durchgeführt werden. Auf diese Weise können unter anderem mehrlagige strukturierte Schichten mit glasartiger Struktur aufgebracht werden. Der Schritt des Entfernens der ersten Beschichtung kann dabei ebenfalls jeweils nach dem zumindest teilweisen Freilegen der ersten Beschichtung erfolgen. Es ist aber auch möglich, diesen Schritt nicht jedesmal, sondern nur nach Aufbringen der letzten Schicht mit glasartiger Struktur durchzuführen. Auf diese Weise kann die erste Beschichtung jeweils auch als Substrat für eine nachfolgende Beschichtung genutzt werden. Dies ermöglicht, daß sich Schichten mit glasartiger Struktur auf dem Substrat erzeugen lassen, die freitragende Bereiche, wie beispielsweise Brücken oder Röhren aufweisen.

Die Unterlage kann selbst als Abdeckung eines Bauelements dienen. In diesem Fall kann das Verfahren vorteilhaft außerdem den Schritt des Verbindens des Substrats mit einem weiteren Substrat, insbesondere einem Halbleiter-Bauelement und/oder einem optoelektronischen Bauelement und/oder einem mikro-elektromechanischen Bauelement umfassen.

Durch das Verfahren kann in der strukturierten Schicht mit glasartiger Struktur beispielsweise ein Phasengitter und/oder zumindest eine optische Komponente und/oder zumindest ein Kanal und/oder zumindest ein Wellenleiter definiert werden. Die Strukturen der Schicht können weiterhin zumindest teilweise aufgefüllt werden. Insbesondere können die Strukturen mit leitendem Material und/oder einem transparenten Material aufgefüllt werden. Durch das Auffüllen mit leitendem Material können elektrische Verbindungen sowohl in Richtung senkrecht zur Oberfläche des Substrats als auch parallel dazu geschaffen werden. Das Auffüllen mit transparentem Material kann außerdem Wellenleiter oder andere optische Komponenten, wie etwa ein Phasengitter definieren.

Elektrische Verbindungen können außerdem vorteilhaft hergestellt werden, wenn das Verfahren außerdem den auch als "Plating" bekannten Schritt des Aufbringens zumindest eines leitenden Bereichs, insbesondere einer Leiterbahn auf die Oberfläche des Substrats und/oder der Schicht mit glasartiger Struktur umfaßt. Dies kann etwa durch Aufdampfen von metallischem Material auf vordefinierte Bereiche der Oberfläche geschehen.

Durch Auffüllen von Strukturen oder Aufbringen leitender Bereiche können auf dem Substrat außerdem passive Bauteile, wie Kondensatoren, Widerstände oder Induktivitäten hergestellt werden.

Eine Kombination dieser Verfahrensschritte erlaubt insbesondere bei mehrlagigen Beschichtungen die Herstellung von Multilayer-Platinen inklusive der Redistribution von Kontakten, dem Routing, der elektrischen Umverdrahtung oder dem Durchkontaktieren elektrischer Anschlüsse durch einzelne Schichten oder das Substrat. Multilayer-Platinen mit Glas als Isolatormaterial sind unter anderem wegen ihrer hervorragenden Hochfrequenzeigenschaften von besonderem Interesse. So zeichnen sich derartige Platinen durch einen niedrigen elektrischen Verlustfaktor aus. Außerdem besitzen diese Platinen eine hohe Formstabilität.

Nach einer Weiterbildung des Verfahrens weist das Substrat zumindest zwei zu beschichtende Oberflächen auf, welche insbesondere im wesentlichen gegenüberliegen, wobei die Schritte des Herstellens zumindest einer negativ strukturierten ersten Beschichtung auf der zumindest einen Oberfläche, des Abscheidens zumindest einer zweiten Schicht, welche ein Material mit glasartiger Struktur aufweist, auf die mit der ersten Beschichtung versehene Oberfläche und des zumindest teilweisen Entfernens der ersten Beschichtung auf jeder der Oberflächen vorgenommen werden. Auf diese Weise können Substrate auf zwei Seiten strukturiert beschichtet werden. Beispielsweise können damit auf gegenüberliegenden Seiten des Substrats optische Elemente, wie etwa Gitter hergestellt werden.

Für eine Weiterverarbeitung des strukturiert beschichteten Substrats kann es außerdem von Vorteil sein, wenn das Verfahren zusätzlich den Schritt des Aufbringens einer Bond-Schicht auf die zweite Schicht umfaßt. Solche Bond-Schichten können beispielsweise eine Seed-Schicht für eine nachfolgende Metallisierung und/oder eine Klebstoffschicht umfassen. Mittels der Bond-Schicht kann dann das Substrat auf der beschichteten Seite mit einer Unterlage verbunden werden. Ebenso können mit einer solchen SEED-Layer strukturiert metallisierte Bereiche erzeugt werden.

Die erste Beschichtung, welche aufgebracht und nach Abscheiden der zweiten Schicht zumindest teilweise wieder entfernt wird, fungiert als Maske für die Strukturierung der zweiten Schicht. Es besteht eine weitere Möglichkeit eines Verfahrens anzugeben, mit welchem strukturierte Aufdampfglasschichten auf einem Substrat auf einer zu beschichtenden Oberfläche abgeschieden werden können, bei welchem das Substrat durch eine Maske hindurch mit einem Aufdampfglas beschichtet wird. Die Maske wird dabei zwischen der zu beschichtenden Oberfläche und der Quelle angeordnet und weist Öffnungen oder Aussparungen entsprechend den vorgesehenen Strukturen der aufzubringenden Glasschicht auf.

Um gut definierte Strukturen zu erhalten, ist es dabei vorteilhaft, die Maske möglichst nahe zu der zu beschichtenden Oberfläche anzuordnen. Gemäß einer Weiterbildung des Verfahrens wird dazu die Maske mit der zu beschichtenden Oberfläche des Substrats in Kontakt gebracht.

Die Maske kann auch beispielsweise mit dem Substrat verbunden werden, um einen engen Kontakt von Maske und Substrat sicherzustellen. Gemäß noch einer Weiterbildung des Verfahrens ist dazu vorgesehen, die Maske mit dem Substrat zu verkleben. Die Maske kann nach erfolgter Beschichtung dann entfernt werden.

Das Verfahren kann auch wiederholt werden, um mehrlagige Beschichtungen zu erhalten, wobei beispielsweise die einzelnen Lagen auch mittels unterschiedlich strukturierter Masken hergestellt werden können, so daß die einzelnen Lagen demgemäß unterschiedliche Strukturen aufweisen.

Im Rahmen der Spezifikation liegt es auch, ein beschichtetes Substrat anzugeben, welches insbesondere mit dem Verfahren herstellbar ist. Dementsprechend weist ein solches beschichtetes Substrat auf zumindest einer Seite eine strukturierte Beschichtung auf, die ein Material mit glasartiger Struktur umfaßt. Die Beschichtung kann gemäß dem Verfahren auf einer negativ strukturierten ersten Beschichtung auf der zumindest einen Seite abgeschieden und die negativ strukturierte Beschichtung zumindest teilweise entfernt sein. Als Material mit glasartiger Struktur eignet sich dabei unter anderem ein Aufdampfglas, jedoch können beispielsweise auch andere Gläser verwendet werden, die etwa durch Sputtern oder CVD abgeschieden werden.

Das Substrat kann zumindest eine elektronische Schaltungsanordnung, insbesondere eine integrierte elektronische Schaltungsanordnung und/oder eine optoelektronische Schaltungsanordnung und/oder zumindest eine mikro-elektromechanische Komponente aufweisen. Ebenso kann das Substrat auch mit einem Bauelement verbunden sein, welches eine integrierte elektronische Schaltungsanordnung und/oder eine optoelektronische Schaltungsanordnung und/oder zumindest eine mikro-elektromechanische Komponente aufweist. Die strukturierte Beschichtung kann dabei eine Aussparung oder eine vollständige oder teilweise Abdeckung für diese Bauelemente darstellen.

Die strukturierte Beschichtung des Substrats kann je nach Anwendungszweck verschiedene funktionelle Strukturen aufweisen. Beispielsweise kann die Beschichtung zumindest einen Kanal oder Graben aufweisen. Ein Kanal kann beispielsweise dazu dienen, eine optische Faser aufzunehmen. Ebenso kann der Kanal mit leitendem Material aufgefüllt werden, wodurch sich elektrische Kontaktierungen herstellen lassen. Dabei kann sich der Kanal sowohl parallel zur beschichteten Oberfläche des Substrats, als auch senkrecht dazu erstrecken.

Vorteilhaft für bestimmte optische Anwendungen ist insbesondere, wenn das Substrat zumindest einen Wellenleiter aufweist. Darüber hinaus können in der strukturierten Beschichtung außerdem zumindest zwei miteinander gekoppelte Wellenleiter definiert werden. Für ein derartiges beschichtetes Substrat ergeben sich eine Vielzahl von Anwendungsmöglichkeiten, wie beispielsweise als integrierter optischer Multiplexer oder Demultiplexer. Allgemein kann die Kopplung mehrerer Wellenleiter auch für eine optische Umverdrahtung verwendet werden.

Außerdem kann durch die Beschichtung zumindest ein Hohlraum definiert sein. Der Hohlraum kann unter anderem dazu dienen, Komponenten, wie etwa mikroelektronische oder mikro-elektromechanische Bauelemente oder auch beispielsweise Fluide aufzunehmen.

Ebenso können neben Hohlräumen auch eine oder mehrere Aussparungen in der Beschichtung vorhanden sein. Zusammen mit einer Aussparung kann die Beschichtung beispielsweise als Abstandhalter für ein weiteres Substrat oder eine optische Komponente dienen.

Auf der strukturierten Beschichtung können außerdem Leiterbahnen vorhanden sein, um verschiedene elektrische oder elektronische Komponenten zu verbinden. Die Leiterbahnen können zum Beispiel durch Auffüllen von Kanälen oder Gräben in der strukturierten Beschichtung oder auch durch Aufbringen von Metallschichten, etwa durch Aufdampfen hergestellt sein. In gleicher Weise können in der Beschichtung auch passive elektronische Bauelemente, wie Kondensatoren, Widerstände oder Induktivitäten definiert sein.

Insbesondere kann das Substrat eine mehrlagige Beschichtung aufweisen. Dazu muß nicht notwendigerweise jede Lage ein glasartiges Material umfassen. Vielmehr können hier verschiedene Materialien und auch verschiedene Strukturierungsverfahren miteinander kombiniert werden.

Das Substrat kann je nach Anwendungszweck ein Material umfassen, welches Glas und/oder Metall und/oder Kunststoff und/oder Keramik und/oder einen Halbleiter, insbesondere Silizium und/oder Galliumarsenid aufweist. Glas- oder Kunststoffsubstrate können beispielsweise als Abdeckung für integrierte elektronische, optoelektronische oder mikro-elektromechanische Bauelemente dienen. Beschichtete Halbleitersubstrate können andererseits zum Beispiel selbst solche Komponenten aufweisen.

Die strukturierte Beschichtung muß sich selbstverständlich nicht nur auf einer Seite des Substrats befinden. Vielmehr kann ein beschichtetes Substrat vorteilhaft auf zwei insbesondere im wesentlichen gegenüberliegenden Seiten je eine strukturierte Beschichtung aufweisen, die ein Material mit glasartiger Struktur umfaßt.

Es liegt außerdem im Rahmen der Spezifikation, eine Vorrichtung zur Durchführung des Verfahrens und/oder zur Herstellung eines strukturiert beschichteten Substrats anzugeben. Eine solche Vorrichtung umfaßt demgemäß neben anderen Einrichtungen zur Bearbeitung eines Substrats eine Einrichtung zum Abscheiden einer Schicht, die ein glasartiges Material umfaßt.

Die Erfindung nach Anspruch 1 wird nachfolgend genauer anhand von Beispielen und unter Bezugnahme auf die beigefügten Figuren näher erläutert. Dabei verweisen gleiche Bezugszeichen in den Figuren auf gleiche oder ähnliche Teile.

Es zeigen:
- Fig. 1A bis 1E: anhand schematischer Querschnittansichten die Verfahrensschritte zur strukturierten Beschichtung von Substraten,
- Fig. 2A und 2B: eine Variante der anhand der Fig. 1C bis 1E dargestellten Verfahrensschritte,
- Fig. 3A bis 3F: anhand schematischer Querschnittansichten die Verfahrensschritte zur mehrlagigen strukturierten Beschichtung eines Substrats,
- Fig. 4A bis 4C: anhand schematischer Ansichten die Verfahrensschritte zur mehrlagigen strukturierten Beschichtung eines Substrats gemäß eines weiteren Beispiels,
- Fig. 5A bis 5C: eine vorteilhafte Weiterbildung des Verfahrens zur Herstellung von Durchkontaktierungen, und
- Fig. 6: ein Beispiel eines mehrlagig beschichteten Substrats,
- Fig. 7: ein Beispiel eines mit einem weiteren Substrat verbundenen, beschichteten Substrats,
- Fig. 8: ein Beispiel eines auf zwei gegenüberliegenden Seiten beschichteten Substrats,
- Fig. 9 und 10: anhand schematischer Querschnitte ein weiteres Beispiel eines Verfahrens zur strukturierten Beschichtung eines Substrats, und
- Fig. 11: eine elektronenmikroskopische Aufnahme eines Ausschnitts der Oberläche eines beschichteten Substrats.

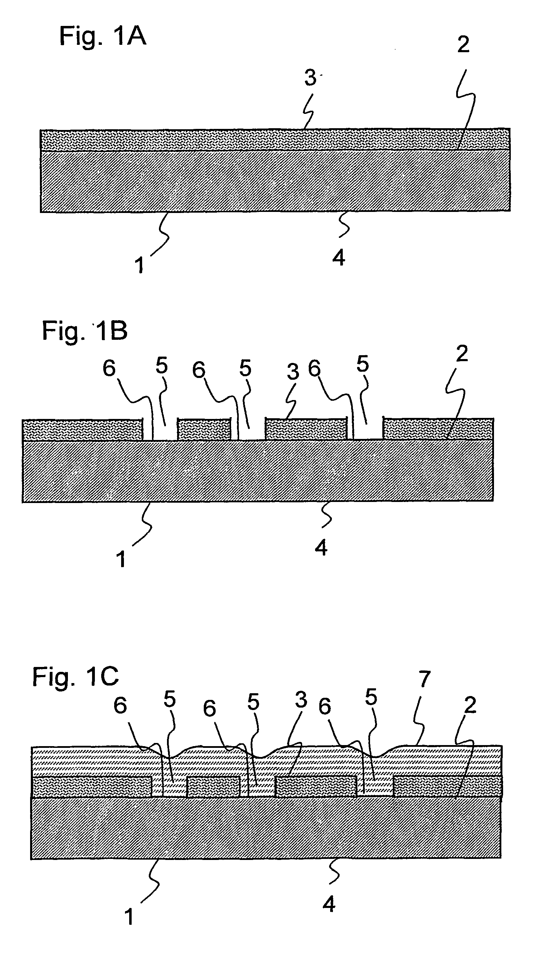

Im folgenden wird zunächst Bezug auf die Figuren 1A bis 1E genommen, welche anhand schematischer Querschnittansichten die Verfahrensschritte zur Herstellung eines strukturierten Substrats darstellen. Zur Herstellung einer strukturierten Beschichtung wird auf das Substrat 1, wie in Fig. 1A gezeigt, zunächst auf der zu beschichtenden Oberfläche 2 eine erste Beschichtung 3 aufgebracht. Das Substrat 1 ist dabei bevorzugt mit weiteren Substraten in einem Waferverbund verbunden. Bei dem in den Figuren 1A bis 1E dargestellten Beispiel ist das Substrat beispielhaft als passives Substrat dargestellt, welches als Abdeckung für ein aktives Substrat, wie beispielsweise einem integrierten elektronischen Bauelement, einem optoelektronischen Bauelement oder einem mikro-elektromechanischen Bauelement dienen kann. Selbstverständlich ist es aber ebenso möglich, strukturierte Beschichtungen mit dem Verfahren direkt auf solche Bauelemente aufzubringen, die dann entsprechend als Substrat 1 dienen. Insbesondere können alle im folgenden erläuterten Beispiele vorteilhaft im Waferverbund durchgeführt werden.

Fig. 1B zeigt eine Querschnittansicht durch das Substrat nach einem weiteren Verfahrensschritt. Hierbei wurden in die erste Beschichtung Strukturen 5 eingefügt. Diese Strukturen schaffen eine zur endgültigen strukturierten Beschichtung in Aufsicht komplementäre, negative Strukturierung. Die Strukturierung ist dabei so durchgeführt worden, daß Bereiche 6 der zu beschichtenden Oberfläche 2 des Substrats 1 freigelegt worden sind.

Die Strukturierung kann unter anderem photolithographisch erfolgen, wobei dazu die Beschichtung 3 beispielsweise einen Photolack umfaßt, in den anschließend durch Belichtung und Entwicklung die Strukturen 5 eingefügt worden sind.

Gemäß einer Variante des Verfahrens wird die Beschichtung 3 nicht nach dem Aufbringen strukturiert, sondern direkt beim Aufbringen der Schicht. Dies kann erreicht werden, indem die Schicht beispielsweise mittels eines geeignete Druckverfahrens, etwa mittels Siebdruck auf das Substrat 1 aufgedruckt wird. Bei dieser Variante des Verfahrens wird der in Fig. 1A gezeigte Verarbeitungszustand des Substrats 1 übersprungen. Selbstverständlich kann diese Variante aber auch mit einer nachträglichen Strukturierung kombiniert werden, indem zum Beispiel ein Photolack strukturiert auf die Oberfläche 2 des Substrats 1 aufgedruckt wird und die aufgedruckten Strukturen dann nachfolgend weiter strukturiert werden, etwa um zusätzliche, feinere Strukturen zu erzeugen. Mit dem anhand von Fig. 1B gezeigten Zustand des Substrates ist der Schritt des Herstellens einer negativ strukturierten Beschichtung abgeschlossen.

In Fig. 1C ist das Substrat nach dem Schritt des Abscheidens einer Schicht 7 mit glasartiger Struktur auf die mit der ersten Beschichtung 3 versehene Oberfläche 2 des Substrats 1 gezeigt. Die Schicht 7 umfaßt dabei bevorzugt ein Aufdampfglas, wobei das Abscheiden des Glases mittels Elektronenstrahlverdampfung auf das mit der ersten strukturierten Beschichtung 3 beschichtete Substrat 1 abgeschieden wird. Die Schicht 7 bedeckt dabei die freigelegten Bereiche 6, sowie die Schicht 3.

Das Abscheiden der zweiten Schicht 7 kann auch durch Plasma-Ionenunterstütztes Aufdampfen erfolgen, um eine besonders dichte und defektfreie Schicht zu erhalten.

Als besonders geeignet hat sich das Aufdampfglas erwiesen, welches folgende Zusammensetzung in Gewichtsprozent aufweist:

| Komponenten | Gew % |
|---|---|
| SiO₂ | 75 - 85 |
| B₂O₃ | 10 - 15 |
| Na₂O | 1 -5 |
| Li₂O | 0,1 - 1 |
| K₂O | 0,1 - 1 |
| Al₂O₃ | 1 - 5 |

Ein bevorzugtes Aufdampfglas dieses Typs ist das Glas 8329 der Firma Schott mit der folgenden Zusammensetzung:

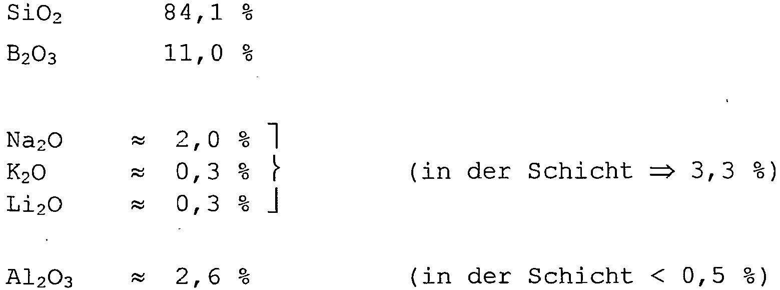

Der elektrische Widerstand beträgt ungefähr 10¹⁰ Ω/cm (bei 100°C),

Dieses Glas weist in reiner Form ferner einen Brechungsindex von etwa 1,470 auf.

Die Dielektrizitätskonstante ε liegt bei etwa 4,7 (bei 25°C, 1MHz), tanδ beträgt etwa 45 x 10⁻⁴ (bei 25°C, 1 MHz). Durch den Aufdampfprozeß und die unterschiedliche Flüchtigkeit der Komponenten dieses Systems ergeben sich leicht unterschiedliche Stöchiometrien zwischen dem Targetmaterial und der aufgedampften Schicht. Die Abweichungen in der aufgedampften Schicht sind in Klammern angegeben.

Ein weitere Gruppe geeigneter Aufdampfgläser weist die folgende Zusammensetzung in Gewichtsprozent auf:

| | |
|---|---|
| Komponenten | Gew % |
| SiO₂ | 65 - 75 |
| B₂O₃ | 2 0 - 30 |
| Na₂O | 0,1 - 1 |
| Li₂O | 0,1 - 1 |
| K₂O | 0,5 - 5 |
| Al₂O₃ | 0,5 - 5 |

Ein bevorzugtes Aufdampfglas aus dieser Gruppe ist das Glas G018-189 der Firma Schott mit der folgenden Zusammensetzung:

| Komponenten: | Gew% |
|---|---|
| SiO₂ | 71 |
| B₂O₃ | 26 |
| Na₂O | 0,5 |
| Li₂O | 0,5 |
| K₂O | 1,0 |
| Al₂O₃ | 1,0 |

Die bevorzugt verwendeten Gläser besitzen insbesondere die in der nachstehenden Tabelle aufgeführten Eigenschaften:

| Eigenschaften | 8329 | G018-189 |
|---|---|---|
| α₂₀₋₃₀₀ [10⁻⁶K⁻¹] | 2,75 | 3,2 |
| Dichte (g/cm³) | 2,201 | 2,12 |
| Transformationspunkt [°C] | 562 | 742 |
| Brechungsindex nd | 1,469 | 1,465 |
| Wasserbeständigkeitklasse nach ISO 719 | 1 | 2 |
| Säurebeständigkeitsklasse nach DIN 12 116 | 1 | 2 |
| Laugenbeständigkeitsklasse nach DIN 52322 | 2 | 3 |
| Dielektrizitätskonstante ε (25 °C) | 4,7 (1MHz) | 3,9 (40GHz) |
| tanδ (25 °C) | 45*10⁻⁴ (1MHz) | 26*10⁻⁴ (40GHz) |

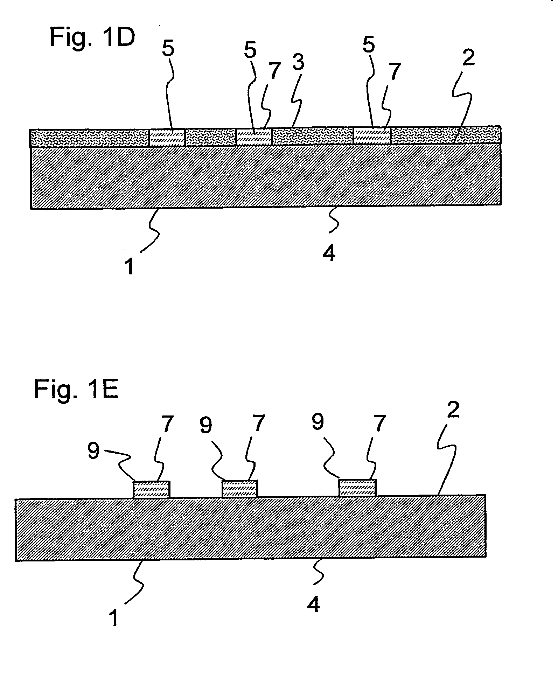

Fig. 1D zeigt das Substrat nach dem nachfolgenden Schritt des Freilegens der ersten Beschichtung 3. Das Freilegen der Beschichtung wurde in dieser Variante des Verfahrens durch Planarisieren der beschichteten Oberfläche vorgenommen. Dazu wurde die beschichtete Oberfläche soweit plan abgeschliffen, bis die Schicht 7 auf der ersten Beschichtung abgetragen ist, so daß die darunter liegende erste Beschichtung 3 wieder freigelegt und zugänglich ist.

Fig. 1E zeigt einen darauffolgenden Verfahrensschritt, bei welchem die erste Beschichtung entfernt worden ist. Durch das Aufdampfen der Schicht 7 auf die negativ strukturierte Beschichtung 3 und das Entfernen der ersten Beschichtung nach deren Freilegung bleibt auf dem Substrat schließlich eine positiv strukturierte zweite Schicht 7 zurück. Die Strukturen 9 der positiv strukturierten zweiten Schicht 7 bedecken dabei die freigelegten, beziehungsweise von der ersten Beschichtung 3 nicht bedeckten Bereiche 6.

Das Entfernen der ersten, negativ strukturierten Beschichtung kann beispielsweise durch Auflösen in einem geeigneten Lösungsmittel oder durch nass- oder trockenchemisches Ätzen erfolgen. Auch eine Verbrennung oder Oxidation in einem Sauerstoffplasma kann vorteilhaft für die Entfernung der Beschichtung angewendet werden.

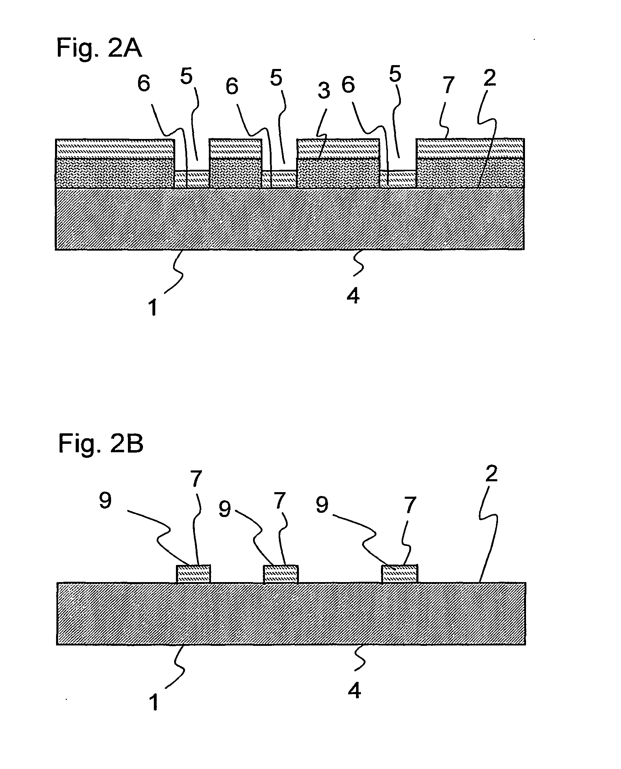

Anhand der Figuren 2A und 2B wird im folgenden eine bevorzugte Variante der anhand der Figuren 1D und 1E gezeigten Verfahrensschritte erläutert. Bei dieser Variante des Verfahrens wird zunächst das Substrat 1 wie anhand der Figuren 1A und 1B gezeigt wurde, durch Aufbringen einer strukturierten ersten Beschichtung 3 vorbereitet. Die Beschichtung 3 weist wieder negative Strukturen 5 auf, welche Bereiche 6 der ersten Oberfläche 2 freilassen. Auf die so vorbereitete Oberfläche des Substrats wird wieder eine zweite Schicht 7, beispielsweise durch Aufdampfen eines Aufdampfglases abgeschieden. Die Schichtdicke der Schicht 7 wird hierbei allerdings nicht so groß gewählt, daß die Schicht 7 geschlossen ist. Dies wird dadurch erreicht, daß für die Schicht 7 eine Schichtdicke gewählt wird, die geringer ist als die Schichtdicke der ersten Beschichtung 3. Diese Phase des Verfahrens ist in Fig. 2A gezeigt.

Die erste Beschichtung 3 kann dann direkt entfernt werden, ohne daß ein Freilegen, etwa durch das anhand von Fig. 1C gezeigte Planarisieren erforderlich ist, da durch die nicht geschlossene zweite Schicht 7 ein Zugang zur ersten Beschichtung 3 erhalten bleibt. Die Bereiche der Schicht 7, welche sich dabei auf der ersten Beschichtung 3 befinden, werden beim Entfernen der ersten Beschichtung 3 abgehoben und dadurch entfernt. Als Ergebnis bleibt, wie Fig. 2B zeigt, wieder eine strukturierte zweite Beschichtung 7 mit positiven Strukturen 9 zurück.

Auf die Strukturen 9 der strukturierten zweiten Schicht 7 der in Fig. 1E oder 2B gezeigten Beispiele kann in einem zusätzlichen Schritt auch noch eine Bond-Schicht aufgebracht werden, welche die der Substratoberfläche abgewandten Oberseiten der Strukturen 9 bedeckt. Eine solche Bond-Schicht kann beispielsweise eine Seed-Schicht für eine nachfolgende Metallisierung oder etwa eine Klebstoffschicht umfassen.

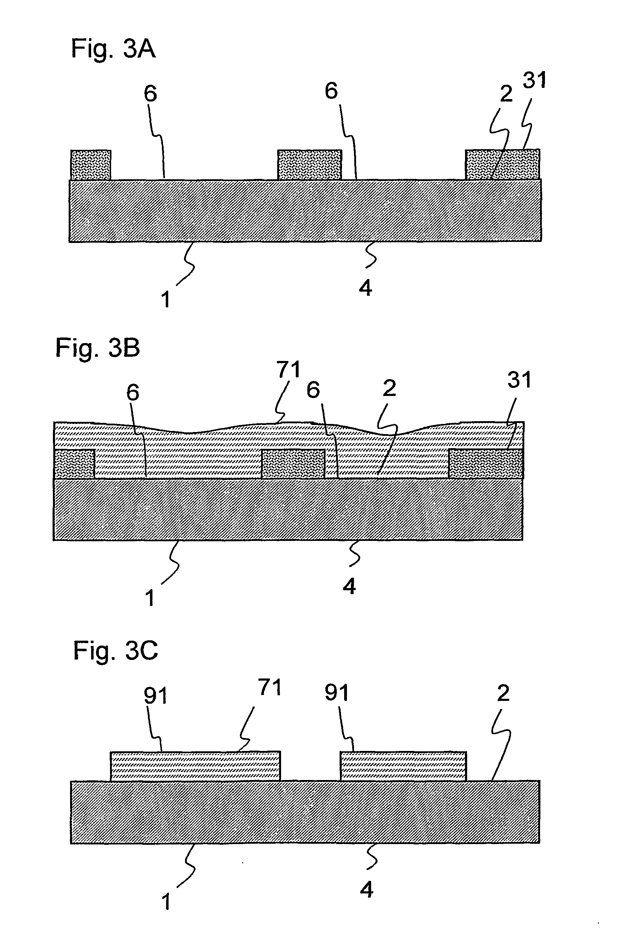

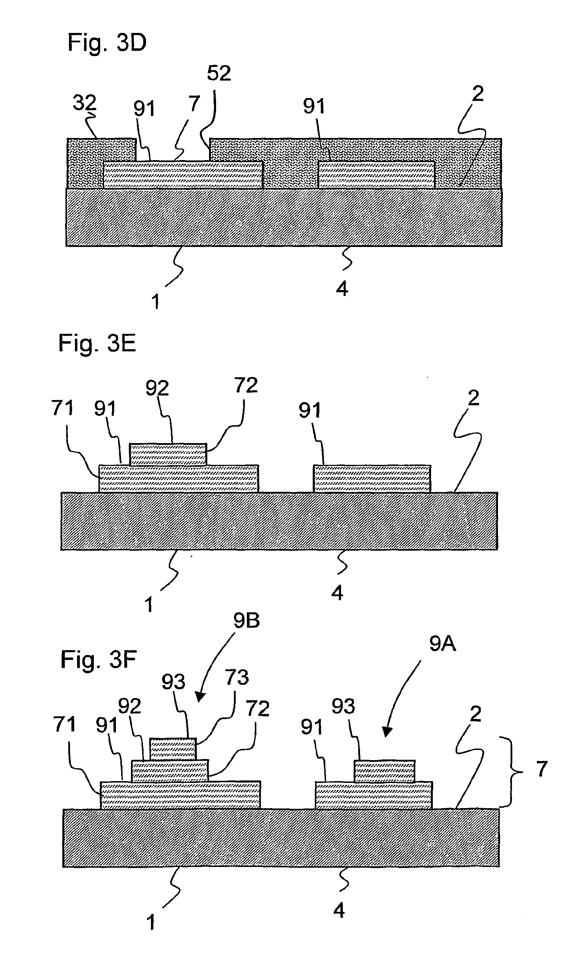

Die Figuren 3A bis 3F zeigen ein weiteres Beispiel des Verfahrens, wobei dieses Beispiel zur Herstellung mehrlagiger strukturierter Beschichtungen dient.

Zum Zwecke der Übersichtlichkeit sind in den Figuren 3A bis 3F dabei einige der anhand der Figuren 1A bis 1E, beziehungsweise 2A und 2B erläuterten Verfahrensschritte nicht im einzelnen dargestellt.

Fig. 3A zeigt ein Substrat 1, auf welchem eine strukturierte erste Beschichtung 31 hergestellt worden ist. Der Bearbeitungszustand des Substrats 1 entspricht somit weitgehend dem der Fig. 1B.

Fig. 3B zeigt das Ergebnis des nachfolgenden Schritts des Abscheidens einer zweiten Schicht 71, welche ein Material mit glasartiger Struktur aufweist, auf die mit der ersten Beschichtung 31 versehene Oberfläche. Die Schicht 71 wird daraufhin wieder durch Abschleifen und Planarisieren der beschichteten Oberfläche des Substrats 1 in den mit der Schicht 31 beschichteten Bereichen abgetragen und die dabei freigelegte Schicht 31 entfernt, so daß eine positiv strukturierte zweite Schicht 71 mit Strukturen 91 stehenbleibt. Dieser Bearbeitungszustand ist in Fig. 3C dargestellt.

Um weitere Lagen einer mehrlagigen Beschichtung aufzubringen, wird auf der so beschichteten Oberfläche eine weitere erste strukturierte Beschichtung 32 hergestellt. Hier befinden sich, wie anhand von Fig. 3E gezeigt ist, die negativen Strukturen 52 der weiteren ersten Beschichtung 32 auf den Strukturen 91 der strukturierten zweiten Schicht 71. Daraufhin wird erneut eine Schicht 72, die ein Material mit glasartiger Struktur aufweist, aufgebracht, die Schicht 32 durch Abschleifen der Schicht 72 daraufhin freigelegt und die Schicht 32 anschließend entfernt.

Diese Verfahrensschritte können gegebenenfalls noch mehrmals wiederholt werden. Fig. 3F zeigt das Substrat nach dem Aufbringen einer weiteren Schicht 73 mit Strukturen 92. Die mehreren Lagen 71, 72 und 73 bilden dabei als ganzes wieder eine strukturierte Beschichtung 7, welche ein glasartiges Material umfaßt und Strukturen 9A und 9B aufweist. Diese Strukturen können dabei auch nach Bedarf so hergestellt werden, daß einzelne Strukturen nicht Material jeder Beschichtung der einzelnen Lagen 71, 72, 73 aufweisen. Die Lagen können außerdem auch unterschiedliche Materialien und Schichtdicken aufweisen. Auf diese Weise können Lagen mit glasartigem Material mit Lagen kombiniert werden, die andere Materialien aufweisen, wie etwa Metall, Keramik, Kunststoff oder halbleitenden Stoffen.

Insbesondere können die einzelnen Lagen 71, 72, 73 einer solchen mehrlagigen Beschichtung auch durch die in den Fig. 2A und 2B dargestellte Variante des Verfahrens durch Abheben der Schichten hergestellt werden.

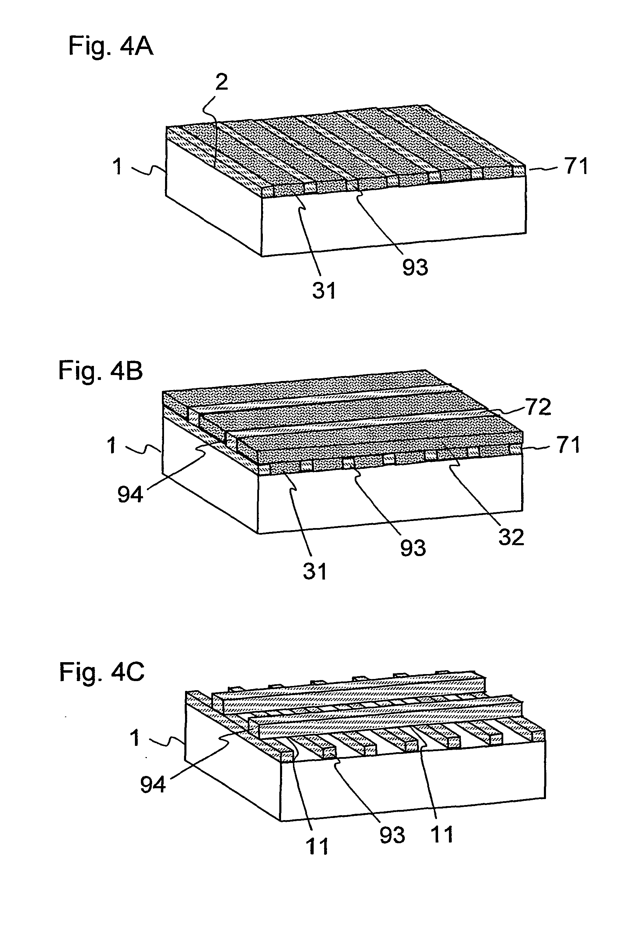

Außerdem muß bei Herstellung einer mehrlagigen strukturierten Beschichtung die negative Beschichtung nicht zwangsläufig nach jedem Aufbringen einer Lage entfernt werden. Eine solche Variante des Verfahrens zeigen die Figuren 4A bis 4C beispielhaft für eine zweilagige strukturierte Beschichtung. Fig. 4A zeigt dazu eine Ansicht des Substrats, welches auf der zu beschichtenden Seite 2 mit einer negativ strukturierten ersten Beschichtung 31 versehen wurde. Die Beschichtung 31 weist dabei beispielhaft Gräben als negative Strukturen auf. Auf der so beschichteten Oberfläche wurde wieder eine Schicht 71, die ein Material mit glasartiger Struktur aufweist, abgeschieden und die Schicht 31 durch Abschleifen der Oberfläche wieder freigelegt. Die Schicht 71 weist entsprechen zu den Gräben komplementäre Strukturen 93 in Form von erhabenen Rippen, beziehungsweise Strängen auf. Fig. 4A entspricht somit dem in Fig. 1D gezeigten Bearbeitungszustand. Derartige Rippen können beispielsweise als Wellenleiter, oder in regelmäßiger Anordnung als Gitter dienen.

Anschließend wird auf gleiche Weise, wie anhand von Fig. 4B gezeigt ist, beim Aufbringen einer weiteren Schicht 72 mit rippen- oder strangförmigen Strukturen 94 verfahren, die als zu Gräben in der weiteren Beschichtung 32 komplementäre, beziehungsweise positive Strukturen ausgebildet sind. Die Strukturen 93 und 94 auf der Oberfläche 2 des Substrats sind dabei beispielhaft zueinander senkrecht angeordnet.

Im Gegensatz zu der anhand der Figuren 3A bis 3F erläuterten Variante des Verfahrens wird hier jedoch die erste strukturierte Beschichtung 31 vor dem Aufbringen einer weiteren Lage 72 nicht entfernt. Beiden Varianten ist dennoch gemeinsam, daß die Schritte des Herstellens einer negativ strukturierten ersten Beschichtung auf die zumindest eine Oberfläche des Substrats 1 und das Abscheidens einer zweiten Schicht, die ein Material mit glasartiger Struktur aufweist, auf die mit der ersten Beschichtung versehene Oberfläche, mehrfach durchgeführt werden.

Fig. 4C zeigt das Substrat 1 mit der fertigen zweilagigen strukturierten Beschichtung 7, welche die Lagen 71 und 72 umfaßt. Nach dem Aufbringen der letzten Lage 72 und des Freilegens der weiteren ersten Beschichtung 32 durch Planarisieren der beschichteten Oberfläche des Substrats wurde die erste Beschichtung 31, sowie die weitere erste Beschichtung 32 entfernt.

Dadurch, daß die erste Beschichtung 31 vor dem Abscheiden der Schicht 72 mit glasartiger Struktur nicht entfernt wird, können die Strukturen einer oder mehrerer Lagen der mehrlagigen Beschichtung freitragende Bereiche aufweisen. Durch die zueinander senkrechte Anordnung der strangförmigen Strukturen 93 und 94 der Lagen 71, beziehungsweise 71 weisen die Strukturen 94 freitragende Bereiche 11 in der Form von Brücken auf, die somit nicht von einer Unterlage oder darunterliegenden Schicht gestützt werden. Mit der hier beschriebene Variante des Verfahrens können so mehrlagige aufeinandergestapelte Gitter erzeugt werden. Derartige Strukturen können beispielsweise vorteilhaft als photonische Kristalle verwendet werden. Die Strukturen können ebenso auch als Wellenleiter dienen. Insbesondere können in einer oder mehreren Lagen durch das Verfahren gekoppelte Wellenleiter hergestellt werden.

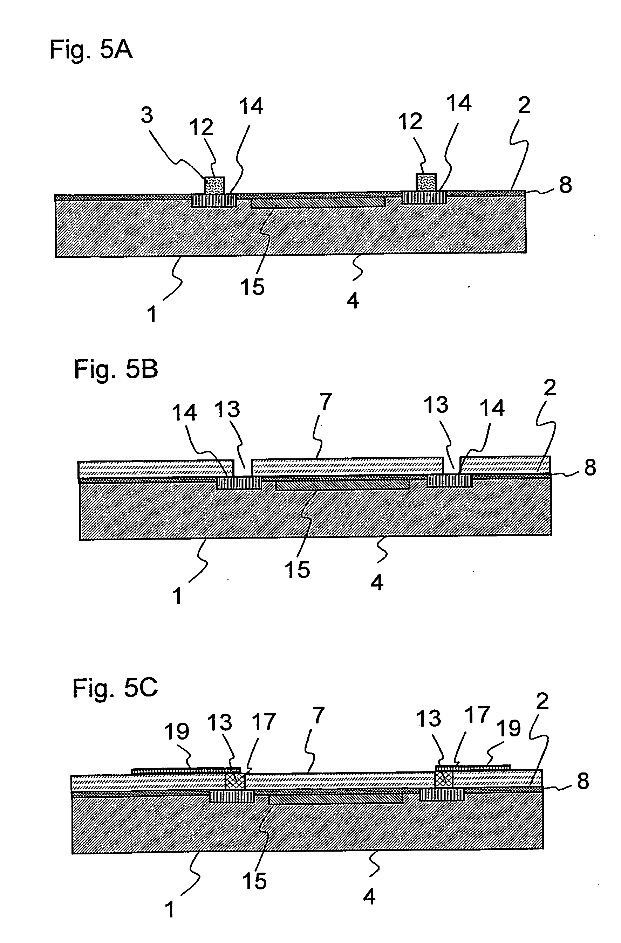

Nachfolgend wird auf die Figuren 5A bis 5C Bezug genommen, welche eine vorteilhafte Weiterbildung des Verfahrens zur Herstellung von Durchkontaktierungen durch eine Verkapselung anhand von Querschnittansichten durch ein Substrat 1 illustrieren. In diesem Fall weist das Substrat 1 beispielhaft auf einer Seite 2 eine aktive Schicht 15 auf. Diese Schicht kann eine integrierte elektronische Schaltungsanordnung oder auch beispielsweise eine optoelektronische Schaltungsanordnung aufweisen. Mit der aktiven Schicht 15 elektrisch verbunden sind Kontaktflächen oder Bondpads 14 zur Kontaktierung der Komponenten der aktiven Schicht 15. Die Oberfläche 2 weist zusätzlich eine Diffusionsbarriere-Schicht 8 auf, welche in der Halbleiterfertigung verbreitet zum Schutz der integrierten Schaltungen der aktiven Schicht eingesetzt wird. Eine solche Diffusionsbarriereschicht 8 kann auch bei der Abscheidung von Aufdampfglas als strukturierte Schicht von Vorteil sein, da Aufdampfglas Natrium-Ionen abgeben kann, welche für die Schaltungen der aktiven Schicht 15 schädlich sein können. Auf die Fläche 2 wurde, wie in Fig. 5A gezeigt, eine strukturierte erste Beschichtung 3 aufgebracht. Die Beschichtung 3 ist so aufgebracht, daß deren Strukturen 12 die Kontaktflächen 14 teilweise oder ganz bedecken, andere Teile der zu beschichtenden Oberfläche 2 aber freigelegt bleiben.

Nachfolgend wird wieder eine Schicht 7 abgeschieden, welche ein glasartiges Material umfaßt. Die beschichtete Seite des Substrats wird daraufhin soweit wieder abgeschliffen und planarisiert, bis die Strukturen 12 der ersten Beschichtung 3 freigelegt sind, woraufhin die freigelegte erste Beschichtung entfernt wird. Alternativ kann auch hier die anhand der Fig. 2A und 2B gezeigte Technik des Abhebens zur Strukturierung eingesetzt werden. Auf diese Weise werden, wie Fig. 5B zeigt, in der zweiten Beschichtung 7 Aussparungen 13 erzeugt, welche die zu den negativen Strukturen 12 positiven oder komplementären Strukturen darstellen.

In einem nachfolgenden Schritt werden die Aussparungen in der zweiten Schicht 7 dann mit einem leitenden Material aufgefüllt, so daß, wie Fig. 5C zeigt, in den Aussparungen leitende Durchkontaktierungen 17 erzeugt werden. Auf diese Weise ist auf der Seite 2 des Substrats 1 eine hermetische Verkapselung hergestellt. Zusätzlich können auf die strukturierte zweite Schicht 7 noch Leiterbahnen 19 aufgebracht werden, die mit den an der Außenseite auf den Durchkontaktierungen 17 entstandenen Kontaktflächen verbunden sind. Dies kann beispielsweise für eine Redistribution der Kontakte verwendet werden. Die Leiterbahnen können vorteilhaft durch Aufdampfen metallischer Schichten hergestellt werden.

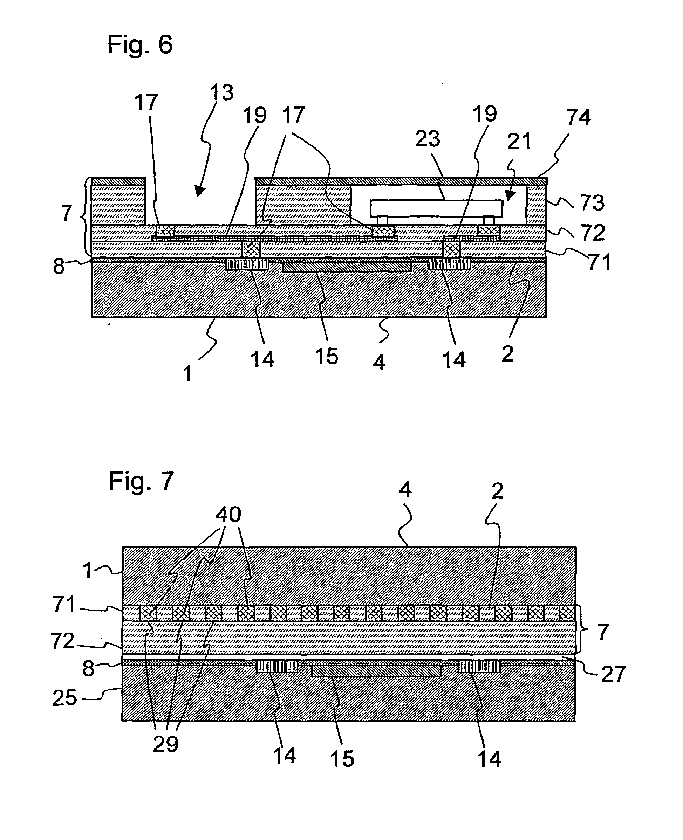

Im folgenden wird Bezug auf Fig. 6 genommen, in welcher beispielhaft ein Substrat 1 mit mehrlagiger Schicht 7 dargestellt ist. Die Schicht 7 weist in diesem Beispiel die Lagen 71, 72, 73 und 74 auf. Dabei umfassen die Lagen 71 bis 73 Materialien mit glasartiger Struktur. Durch eine in Lage 73 geschaffene Aussparung und die als Abdeckung dienende Lage 74 wird in der mehrlagigen Schicht 7 unter anderem ein Hohlraum 21 definiert. Im Hohlraum ist ein Bauelement 23 untergebracht, welches über Durchkontaktierungen 17 und Leiterbahnen mit der aktiven Schicht 15 und einer in einer weiteren Aussparung 13 befindlichen Durchkontaktierung 17 angeschlossen ist. Das Bauteil kann beispielsweise einen mikro-elektromechanischen Aktuator oder ein piezoelektrisches Element oder auch einen Sensor umfassen. Ebenso können neben aktiven Bauelementen in einem solchen Hohlraum auch passive Elemente, wie beispielsweise passive Filterelemente untergebracht werden.

Die in Fig. 6 gezeigte Anordnung ist lediglich beispielhaft. Sie zeigt jedoch, daß sich durch Kombination von Durchkontaktierungen in den Schichten, Leiterbahnen, Hohlräumen und Aussparungen in einfacher Weise komplexe mehrlagige Beschichtungen für elektronische oder optoelektronische Anwendungen herstellen lassen. Außerdem lassen sich durch geeignete Strukturierung der Schicht oder der Schichten, die ein glasartiges Material aufweisen, optische Komponenten realisieren. Fig. 7 zeigt dazu ein Beispiel, bei welchem durch die Strukturierung ein Phasengitter hergestellt wurde.

Dabei wurde zunächst wie anhand der Figuren 1A bis 1E, beziehungsweise der Figuren 2A und 2B erläutert wurde, eine zweite Beschichtung 71 auf der Seite 2 des Substrats 1 hergestellt. Zur Realisierung eines Phasengitters umfassen diese Strukturen vorteilhaft regelmäßig angeordnete Gräben 40, die sich geradlinig oder gekrümmt entlang der Oberfläche 2 in der strukturierten Schicht 71, die ein glasartiges Material umfaßt, erstrecken. Mit entlang der Oberfläche des Substrats 1 gekrümmt verlaufenden Gräben, können beispielsweise Fokussierungseffekte erreicht werden. Zur Herstellung eines Phasengitters werden die Gräben 40 in der Schicht 7 mit einem transparenten Material 29 aufgefüllt, welches bevorzugt einen anderen Brechungsindex als die Schicht 71 aufweist. Auf das so geschaffenen Phasengitter in der Schicht 71 ist eine weitere Schicht 72 aufgebracht, die als Abstandhalter dient.

Das so hergestellte beschichtete Substrat 1 dient in diesem Ausführungsbeispiel selbst als Abdeckung für ein weiteres Substrat 25. Dazu wird das beschichtete Substrat 1 nach Herstellung der strukturierten Beschichtung 7 mit dem weiteren Substrat 25 mittels einer Verbindungsschicht 27 verbunden. Das Substrat 25 weist eine aktive Schicht 15 auf. Beispielsweise kann das Substrat ein optoelektronisches Bauelement oder ein mikroelektromechanisches Bauelement sein, welches in seiner Funktion mit dem Phasengitter der strukturierten Beschichtung 7 zusammenwirkt.

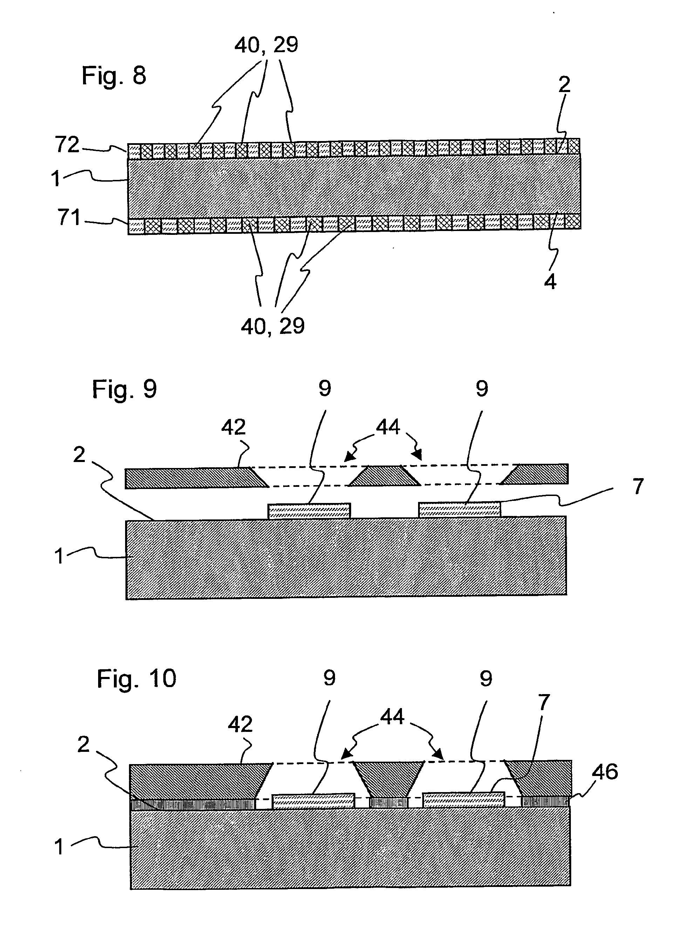

Fig. 8 zeigt ein Beispiel eines beschichteten Substrats 1, welche auf zwei gegenüberliegenden Seiten 2, 4 jeweils strukturierte Schichten 71 und 72 aufweist. Die strukturierten Schichten 71 und 72 wurden dabei wie anhand von Fig. 7 dargestellt wurde, als Phasengitter hergestellt. Die Phasengitter auf den gegenüberliegenden Seiten weisen außerdem verschiedene Perioden auf. Ein solches beschichtetes Substrat kann beispielsweise als optischer Filter mit hoher Auflösung verwendet werden. Selbstverständlich können auch andere strukturierte Beschichtungen, wie beispielsweise eine anhand von Fig. 6 dargestellte, mehrlagige strukturierte Schicht 7 auf eine oder beide Seiten eines solchen mehrseitig beschichteten Substrats aufgebracht werden.

Im folgenden wird auf die Fig. 9 und 10 Bezug genommen, welche anhand schematischer Querschnitte zweier weiterer Beispiele eines Verfahrens zum Herstellen einer strukturierten glasartigen Schicht auf einem Substrat darstellen.

Zur Herstellung einer solche Schicht wird, wie in Fig. 9 dargestellt ist, vor der zu beschichtenden Oberfläche 2 des Substrats 1 eine Maske 42 angeordnet, so daß sich die Maske zwischen der Oberfläche 2 und der nicht dargestellten Beschichtungsquelle befindet. Bevorzugt wird als Beschichtungsquelle wieder ein Verdampfer, insbesondere ein Elekronenstrahlverdampfer für Aufdampfglas verwendet. Die Maske 42 weist Öffnungen und/oder Aussparungen 44 in Form und an vorgesehener Position der aufzubringenden Strukturen auf. Nachdem die Maske 42 vor der Oberfläche 2 positioniert wurde, wird die Schicht 7 abgeschieden, die entsprechend den Öffnungen 44 dann Strukturen 9 aufweist. Die Maske 42 kann auch, anders als in Fig. 9 dargestellt, in direkten Kontakt mit der Oberfläche 2 gebracht werden, um einen möglichst geringen Abstand zur Oberfläche 2 zu erhalten. Die Maske 42 kann insbesondere auch mit dem Substrat 1 verbunden werden, so daß eventuelle Verformungen der Maske oder des Substrats nicht zu einem erhöhten Abstand der Maske zu Oberfläche 2 führen. Eine solche Weiterbildung des Verfahrens ist in Fig. 10 dargestellt. Bei der in Fig. 10 gezeigten Anordnung wurde das Substrat vor dem Aufdampfen mit der Maske 42 durch eine Verklebung 46 verbunden. Nach dem Abscheiden der Aufdampfglasschicht kann dann die Maske wieder abgelöst werden, so daß ähnlich zu den vorstehend beschriebenen Beispielen wieder ein Erzeugnis mit strukturierter Aufdampfglasschicht auf der Oberfläche 2 des Substrats erhalten wird.

Selbstverständlich kann das Substrat auch auf mehreren Seiten beschichtet werden. Außerdem können auch analog zu den anhand der Fig. 3A bis 3F und/oder der Fig. 4A bis 4C beschriebenen Beispielen auf mehreren Seiten, insbesondere beidseitig auf gegenüberliegenden Seiten des Substrats mehrlagige strukturierte Beschichtungen aufgebracht werden.

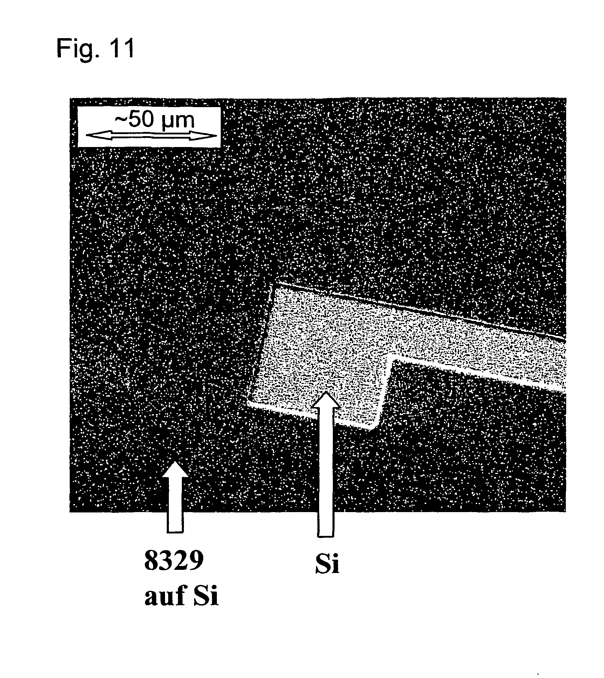

Fig. 11 zeigt eine elektronenmikroskopische Aufnahme eines Ausschnitts der Oberfläche eines beschichteten Substrats. Als Substrat wurde Silizium und als Aufdampfglas das oben angegebene Glas 8329 verwendet. Die Strukturen in der Aufdampfglasschicht wurden durch Aufdampfen auf eine strukturierte erste Beschichtung und Lift-off, beziehungsweise Abheben der Bereiche der Glasschicht auf der ersten Beschichtung durch Auflösen der ersten Beschichtung hergestellt. Anhand der Aufnahme läßt sich erkennen, daß sich mit dem Verfahren sehr gut definierte Glasstrukturen auf Substraten erzeugen lassen.

**Bezugszeichenliste**

| | |
|---|---|
| 1 | Substrat |
| 2 | zu beschichtende, erste Oberfläche des Substrats |
| 3, 31, 32 | erste Beschichtung |
| 4 | gegenüberliegende, zweite Oberfläche des Substrats |
| 5, 12 | negative Strukturen in erster Beschichtung 3 |
| 6 | freigelegter Bereich auf Oberfläche 2 |
| 7 | strukturierte Schicht |
| 8 | Diffusionssperrschicht |
| 9, 9A, 9B, | positive Strukturen der Schicht 7 |
| 94 | strangförmige Strukturen in zweiter Schicht 7 |
| 71, 72, 73, 74 | Lagen einer mehrlagigen strukturierten Schicht 7 |
| 91, 92, 93 | Strukturen der Lagen 71, 72, 73 |
| 11 | freitragende Bereiche |
| 13 | Aussparung in Schicht 7 |
| 14 | Kontaktflächen |
| 15 | aktive Schicht |
| 17 | Durchkontaktierung |
| 19 | Leiterbahnen |
| 21 | Hohlraum |
| 23 | Bauelement |
| 25 | weiteres Substrat |
| 27 | Verbindungsschicht |
| 29 | transparente Auffüllung |
| 40 | Gräben in Schicht 7 |
| 42 | Maske |
| 44 | Öffnung in 42 |
| 46 | Verklebung |

## Patentansprüche

1. Verfahren zur strukturierten Beschichtung eines Substrats (1) mit zumindest einer zu beschichtenden Oberfläche (2), umfassend die Schritte:
- Herstellen zumindest einer negativ strukturierten ersten Beschichtung (3, 31, 32) auf der zumindest einen Oberfläche (2),
- Abscheiden zumindest einer zweiten Schicht (7, 71, 72, 73), welche ein Aufdampfglas umfaßt, auf die mit der ersten Beschichtung (3, 31, 32) versehene Oberfläche (2),
- zumindest teilweises Entfernen der ersten Beschichtung (3, 31, 32), **dadurch gekennzeichnet, daß** das Abscheiden der zweiten Schicht (7, 71, 72, 73) durch Aufdampfen den Schritt des Plasma-Ionenunterstützten Elektronenstrahlverdampfens umfaßt.

2. Verfahren nach Anspruch 1, **dadurch gekennzeichnet, daß** der Schritt des Herstellens einer negativ strukturierten ersten Beschichtung (3, 31, 32) auf der zumindest einen Oberfläche (2) den Schritt des Freilegens von Bereichen (6) der zumindest einen zu beschichtenden Oberfläche (2) umfaßt.

3. Verfahren nach Anspruch 1 oder 2, **dadurch gekennzeichnet, daß** das Substrat (1) Bestandteil eines Wafers ist und das Verfahren im Waferverbund durchgeführt wird.

4. Verfahren nach einem der vorstehenden Ansprüche, **dadurch gekennzeichnet, daß** der Schritt des Aufdampfens einer Schicht, welche ein Aufdampfglas umfaßt, den Schritt des Verdampfens von Aufdampfmaterial, welches auf der Oberfläche (2) abgeschieden ein Material mit glasartiger Struktur bildet, aus einer einzelnen Quelle umfaßt.

5. Verfahren nach einem der vorstehenden Ansprüche, **dadurch gekennzeichnet, daß** der Schritt des Aufdampfens einer Schicht, welche ein Aufdampfglas umfaßt, den Schritt des Coverdampfens aus zumindest zwei Quellen umfaßt.

6. Verfahren nach einem der vorstehenden Ansprüche, **dadurch gekennzeichnet, daß** der Schritt des Abscheidens einer zweiten Schicht (7, 71, 72), welche ein Aufdampfglas umfaßt, den Schritt des Abscheidens einer Schicht mit entlang einer Richtung senkrecht zur Oberfläche variierender Zusammensetzung umfaßt.

7. Verfahren nach einem der vorstehenden Ansprüche, **dadurch gekennzeichnet, daß** der Schritt des Abscheidens einer zweiten Schicht (7, 71, 72, 73), welche ein Aufdampfglas umfaßt, den Schritt des Abscheidens einer Schicht (7, 71, 72, 73) umfaßt, welche ein zumindest binäres Stoffsystem aufweist.

8. Verfahren nach einem der vorstehenden Ansprüche, **dadurch gekennzeichnet, daß** der Schritt des Abscheidens einer zweiten Schicht (7, 71, 72, 73), welche ein Aufdampfglas umfaßt, den Schritt des Coabscheidens von organischem Material umfaßt.

9. Verfahren nach einem der vorstehenden Ansprüche, **dadurch gekennzeichnet, daß** der Schritt des Herstellens einer negativ strukturierten ersten Beschichtung (3, 31, 32) den Schritt des Belackens, insbesondere des Belackens mittel Spin-Coating und/oder Aufsprühen und/oder der Elektrodeposition einer ersten Beschichtung (3, 31, 32) umfaßt.

10. Verfahren nach einem der vorstehenden Ansprüche, **dadurch gekennzeichnet, daß** der Schritt des Herstellens einer negativ strukturierten ersten Beschichtung (3, 31, 32) den Schritt des Prägens einer ersten Beschichtung (3, 31, 32) umfaßt.

11. Verfahren nach einem der vorstehenden Ansprüche, **dadurch gekennzeichnet, daß** der Schritt des Herstellens einer negativ strukturierten ersten Beschichtung (3, 31, 32) den Schritt des Aufbringens einer Photoresist-Folie umfaßt.

12. Verfahren nach einem der vorstehenden Ansprüche, **dadurch gekennzeichnet, daß** der Schritt des Herstellens einer negativ strukturierten ersten Beschichtung (3, 31, 32) den Schritt des strukturierten Aufdruckens einer ersten Beschichtung (3, 31, 32), insbesondere des strukturierten Aufdruckens mittels Siebdruck umfaßt.

13. Verfahren nach einem der vorstehenden Ansprüche, **dadurch gekennzeichnet, daß** der Schritt des Herstellens einer negativ strukturierten ersten Beschichtung (3, 31, 32) den Schritt des lithographischen Strukturierens der ersten Beschichtung (3, 31, 32) und/oder den Schritt des lithographischen Graustufenstrukturierens umfaßt.

14. Verfahren nach einem der vorstehenden Ansprüche, **dadurch gekennzeichnet, daß** der Schritt des Herstellens einer negativ strukturierten ersten Beschichtung (3, 31, 32) auf die zumindest eine Oberfläche (2) den Schritt des Aufbringens einer photostrukturierbaren Schicht (3, 31, 32) umfaßt.

15. Verfahren nach Anspruch 14, **dadurch gekennzeichnet, daß** der Schritt des Aufbringens einer photostrukturierbaren Schicht (3, 31, 32) den Schritt des Aufbringens eines Photolacks umfaßt.

16. Verfahren nach einem der vorstehenden Ansprüche, **dadurch gekennzeichnet, daß** der Schritt des zumindest teilweise Entfernens der ersten Beschichtung (3, 31, 32) den Schritt des Auflösens der Beschichtung (3, 31, 32) in einem Lösungsmittel umfaßt.

17. Verfahren nach einem der vorstehenden Ansprüche, **dadurch gekennzeichnet, daß** der Schritt des zumindest teilweise Entfernens der ersten Beschichtung (3, 31, 32) den Schritt des nasschemischen Entfernens der Beschichtung umfaßt.

18. Verfahren nach einem der vorstehenden Ansprüche, **dadurch gekennzeichnet, daß** der Schritt des zumindest teilweise Entfernens der ersten Beschichtung (3, 31, 32) den Schritt des trockenchemischen Entfernens der Beschichtung (3, 31, 32), insbesondere den Schritt des Verbrennens der ersten Beschichtung in einem oxidierenden Plasma umfaßt.

19. Verfahren nach einem der vorstehenden Ansprüche, **dadurch gekennzeichnet, daß** der Schritt des zumindest teilweise Entfernens der ersten Beschichtung (3, 31, 32) den Schritt des Abhebens von Bereichen der zumindest einen zweiten Schicht (7, 71, 72, 73) umfaßt.

20. Verfahren nach einem der vorstehenden Ansprüche, **gekennzeichnet durch** den Schritt des zumindest teilweise Freilegens der ersten Beschichtung (3, 31, 32).

21. Verfahren nach Anspruch 20, **dadurch gekennzeichnet, daß** der Schritt des zumindest teilweise Freilegens der ersten Beschichtung (3, 31, 32) den Schritt des Planarisierens der beschichteten Oberfläche umfaßt.

22. Verfahren nach Anspruch 20 oder 21, **dadurch gekennzeichnet, daß** der Schritt des teilweise Freilegens der ersten Beschichtung (3, 31, 32), den Schritt des mechanischen Abtragens, insbesondere mittels Schleifen und/oder Läppen und/oder Polieren umfaßt.

23. Verfahren nach einem der vorstehenden Ansprüche, **gekennzeichnet durch** den Schritt des Nachbehandelns der positiv strukturierten zweiten Schicht, insbesondere mittels nasschemischem und/oder trockenchemischem und/oder thermischem Reflow und/oder Dotierung.

24. Verfahren nach einem der vorstehenden Ansprüche, **dadurch gekennzeichnet, daß** die Schritte des Herstellens einer negativ strukturierten ersten Beschichtung (3, 31, 32) auf der zumindest einen Oberfläche (2) und des Abscheidens zumindest einer zweiten Schicht (7, 71, 72, 73), welche ein Aufdampfglas umfaßt, mehrfach durchgeführt werden.

25. Verfahren nach einem der vorstehenden Ansprüche, **gekennzeichnet durch** den Schritt des Verbindens des Substrats (1) mit einem weiteren Substrat (25), insbesondere einem Halbleiter-Bauelement und/oder einem optoelektronischen Bauelement und/oder einem mikro-elektromechanischen Bauelement.

26. Verfahren nach einem der vorstehenden Ansprüche, **dadurch gekennzeichnet, daß** durch das Verfahren zumindest ein Phasengitter und/oder zumindest eine optische Komponente und/oder zumindest ein Kanal (40) und/oder zumindest ein Wellenleiter (93, 94) in der zweiten Schicht (7, 71, 72), welche ein welche ein Aufdampfglas umfaßt, definiert wird.

27. Verfahren nach einem der vorstehenden Ansprüche, **gekennzeichnet durch** den Schritt des zumindest teilweise Auffüllens von Strukturen der zweiten Schicht, welche ein Aufdampfglas umfaßt, insbesondere des Auffüllens mit leitendem Material und/oder einem transparenten Material (29).

28. Verfahren nach einem der vorstehenden Ansprüche, **gekennzeichnet durch** den Schritt des Aufbringens zumindest eines leitenden Bereichs, insbesondere einer Leiterbahn (19) auf die Oberfläche des Substrats und/oder der zumindest einer zweiten Schicht (7, 71, 72, 73).

29. Verfahren nach Anspruch 27 oder 28, **dadurch gekennzeichnet, daß** der Schritt des Auffüllens von Strukturen der zweiten Schicht und/oder der Schritt des Aufbringens zumindest eines leitenden Bereichs den Schritt des Herstellens zumindest eines passiven elektronischen Bauteils, insbesondere eines Kondensators und/oder eines Widerstands und/oder einer Induktivität umfaßt.

30. Verfahren nach einem der vorstehenden Ansprüche, **dadurch gekennzeichnet, daß** das Substrat zumindest zwei zu beschichtende Oberflächen (2, 4) aufweist, welche insbesondere im wesentlichen gegenüberliegen, wobei die Schritt
- des Herstellens zumindest einer negativ strukturierten ersten Beschichtung (3, 31, 32) auf der zumindest einen Oberfläche (2),
- des Abscheidens zumindest einer zweiten Schicht (7, 71, 72, 73), welche ein Aufdampfglas umfaßt, auf die mit der ersten Beschichtung (3, 31, 32) versehene Oberfläche (2), und des
- zumindest teilweise Entfernens der ersten Beschichtung (3, 31, 32) auf jeder der Oberflächen (2, 4) vorgenommen werden.

31. Verfahren nach einem der vorstehenden Ansprüche, **gekennzeichnet durch** den Schritt des Aufbringens einer Bond-Schicht auf die zweite Schicht (7, 71, 72, 73), insbesondere einer Bond-Schicht, welche eine Seed-Schicht für eine nachfolgende Metallisierung und/oder eine Klebstoffschicht umfaßt.

## Claims

1. Method for the structured coating of a substrate (1) having at least one surface (2) to be coated, comprising the steps of:
- producing at least one negatively structured first coating (3, 31, 32) on the at least one surface (2);
- depositing at least one second layer (7, 71, 72, 73) on the surface (2) which is provided with the first coating (3, 31, 32), said at least one second layer including a vapour-deposited glass;
- at least partially removing the first coating (3, 31, 32), **characterised in that** the deposition of the second layer (7, 71, 72, 73) by vapour deposition comprises the step of plasma ion-enhanced electron beam evaporation.

2. Method as claimed in claim 1, **characterised in that** the step of producing a negatively structured first coating (3, 31, 32) on the at least one surface (2) comprises the step of uncovering regions (6) of the at least one surface (2) to be coated.

3. Method as claimed in claim 1 or 2, **characterised in that** the substrate (1) is part of a wafer and the method is carried out on the wafer.

4. Method as claimed in any one of the preceding claims, **characterised in that** the step of vapour deposition of a layer which includes a vapour-deposited glass comprises the step of evaporation of vapour-deposited material, which forms a material with a vitreous structure deposited on the surface (2), from a single source.

5. Method as claimed in any one of the preceding claims, **characterised in that** the step of vapour deposition of a layer which includes a vapour-deposited glass comprises the step of co-evaporation from at least two sources.

6. Method as claimed in any one of the preceding claims, **characterised in that** the step of depositing a second layer (7, 71, 72) which includes a vapour-deposited glass comprises the step of depositing a layer with a composition which varies in a direction perpendicular to the surface.

7. Method as claimed in any one of the preceding claims, **characterised in that** the step of depositing a second layer (7, 71, 72. 73) which includes a vapour-deposited glass comprises the step of depositing a layer (7, 71, 72, 73) which comprises an at least binary materials system.

8. Method as claimed in any one of the preceding claims, **characterised in that** the step of depositing a second layer (7, 71, 72, 73) which includes a vapour-deposited glass comprises the step of co-depositing organic material.

9. Method as claimed in any one of the preceding claims, **characterised in that** the step of producing a negatively structured first coating (3, 31, 32) comprises the step of lacquering, in particular lacquering by means of spin-coating and/or spraying and/or electro-deposition of a first coating (3, 31, 32).

10. Method as claimed in any one of the preceding claims, **characterised in that** the step of producing a negatively structured first coating (3, 31, 32) comprises the step of embossing a first coating (3, 31, 32).

11. Method as claimed in any one of the preceding claims, **characterised in that** the step of producing a negatively structured first coating (3, 31, 32) comprises the step of applying a photoresist film.

12. Method as claimed in any one of the preceding claims, **characterised in that** the step of producing a negatively structured first coating (3, 31, 32) comprises the step of structured printing a first coating (3, 31, 32), in particular structured printing by means of screen printing.

13. Method as claimed in any one of the preceding claims, **characterised in that** the step of producing a negatively structured first coating (3, 31, 32) comprises the step of lithographically structuring the first coating (3, 31, 32) and/or the step of lithographic grey scale structuring.

14. Method as claimed in any one of the preceding claims, **characterised in that** the step of producing a negatively structured first coating (3, 31, 32) on the at least one surface (2) comprises the step of applying a photostructurable layer (3, 31, 32).

15. Method as claimed in claim 14, **characterised in that** the step of applying a photostructurable layer (3, 31, 32) comprises the step of applying a photoresist.

16. Method as claimed in any one of the preceding claims, **characterised in that** the step of at least partially removing the first coating (3, 31, 32) comprises the step of dissolving the coating (3, 31, 32) in a solvent.

17. Method as claimed in any one of the preceding claims, **characterised in that** the step of at least partially removing the first coating (3, 31, 32) comprises the step of wet-chemical removal of the coating.

18. Method as claimed in any one of the preceding claims, **characterised in that** the step of at least partially removing the first coating (3, 31, 32) comprises the step of dry-chemical removal of the coating (3, 31, 32), in particular the step of burning the first coating in an oxidising plasma.

19. Method as claimed in any one of the preceding claims, **characterised in that** the step of at least partially removing the first coating (3, 31, 32) comprises the step of lifting off regions of the at least one second layer (7, 71, 72, 73).

20. Method as claimed in any one of the preceding claims, **characterised by** the step of at least partially uncovering the first coating (3, 31, 32).

21. Method as claimed in claim 20, **characterised in that** the step of at least partially uncovering the first coating (3, 31, 32) comprises the step of planarising the coated surface.

22. Method as claimed in claim 20 or 21, **characterised in that** the step of partially uncovering the first coating (3, 31, 32) comprises the step of mechanical abrasion, in particular by means of grinding and/or lapping and/or polishing.

23. Method as claimed in any one of the preceding claims, **characterised by** the step of aftertreating the positively structured second layer, in particular by means of a wet-chemical process and/or a dry-chemical process and/or a thermal reflow process and/or a doping process.

24. Method as claimed in any one of the preceding claims, **characterised in that** the steps of producing a negatively structured first coating (3, 31, 32) on the at least one surface (2) and depositing at least one second layer (7, 71, 72, 73) which includes a vapour-deposited glass are performed multiple times.

25. Method as claimed in any one of the preceding claims, **characterised by** the step of connecting the substrate (1) to a further substrate (25), in particular a semiconductor component and/or an optoelectronic component and/or a micro-electromechanical component.

26. Method as claimed in any one of the preceding claims, **characterised in that** at least one phase grating and/or at least one optical component and/or at least one channel (40) and/or at least one waveguide (93, 94) is defined by the method in the second layer (7, 71, 72) which includes a vapour-deposited glass.

27. Method as claimed in any one of the preceding claims, **characterised by** the step of at least partially filling structures of the second layer which includes a vapour-deposited glass, in particular filling with a conductive material and/or a transparent material (29).

28. Method as claimed in any one of the preceding claims, **characterised by** the step of applying at least one conductive region, in particular a conductive track (19), to the surface of the substrate and/or the at least one second layer (7, 71, 72, 73).

29. Method as claimed in claim 27 or 28, **characterised in that** the step of filling structures of the second layer and/or the step of applying at least one conductive region comprise(s) the step of producing at least one passive electronic component, in particular a capacitor and/or a resistor and/or an inductance.

30. Method as claimed in any one of the preceding claims, **characterised in that** the substrate comprises at least two surfaces (2, 4) to be coated, which in particular lie substantially opposite one another, wherein the step of
- producing at least one negatively structured first coating (3, 31, 32) on the at least one surface (2),
- depositing at least one second layer (7, 71, 72, 73) on the surface (2) which is provided with the first coating (3, 31, 32), said at least one second layer including a vapour-deposited glass, and
- at least partially removing the first coating (3, 31, 32) are performed on each of the surfaces (2, 4).

31. Method as claimed in any one of the preceding claims, **characterised by** the step of applying a bonding layer to the second layer (7, 71, 72, 73), in particular a bonding layer which comprises a seed layer for a subsequent metallisation and/or an adhesive layer.

## Revendications

1. Procédé de revêtement structuré d'un substrat (1) ayant au moins une surface (2) à revêtir, comprenant les étapes suivantes :
- fabrication d'au moins un premier revêtement (3, 31, 32) négativement structuré sur l'au moins une surface (2),
- dépôt d'au moins une deuxième couche (7, 71, 72, 73), comprenant un verre de dépôt en phase vapeur sur la surface (2) pourvue du premier revêtement (3, 31, 32),
- retrait au moins partiel du premier revêtement (3, 31, 32),
**caractérisé en ce que** le dépôt de la deuxième couche (7, 71, 72, 73) comprend l'étape de vaporisation par faisceau d'électrons assisté par plasma à faisceau d'ions.

2. Procédé selon la revendication 1, **caractérisé en ce que** l'étape de fabrication d'un premier revêtement (3, 31, 32) négativement structuré sur l'au moins une surface (2) comprend l'étape de dégagement de zones (6) de l'au moins une surface (2) à revêtir.

3. Procédé selon la revendication 1 ou 2, **caractérisé en ce que** le substrat (1) est partie intégrante d'une tranche et ledit procédé étant exécuté dans l'ensemble de tranche.

4. Procédé selon l'une des revendications précédentes, **caractérisé en ce que** l'étape de dépôt en phase vapeur d'une couche comprenant un verre de dépôt en phase vapeur comprend l'étape d'évaporation depuis une seule source d'une substance de dépôt en phase vapeur formant une substance à structure vitreuse une fois déposée sur la surface (2).

5. Procédé selon l'une des revendications précédentes, **caractérisé en ce que** l'étape de dépôt en phase vapeur d'une couche comprenant un verre de dépôt en phase vapeur comprend l'étape de co-vaporisation depuis au moins deux sources.

6. Procédé selon l'une des revendications précédentes, **caractérisé en ce que** l'étape de dépôt d'une deuxième couche (7, 71, 72) comprenant un verre de dépôt en phase vapeur comprend l'étape de dépôt d'une couche de composition variable le long d'une direction perpendiculaire à la surface.

7. Procédé selon l'une des revendications précédentes, **caractérisé en ce que** l'étape de dépôt d'une deuxième couche (7, 71, 72, 73) comprenant un verre de dépôt en phase vapeur comprend l'étape de dépôt d'une couche (7, 71, 72, 73) présentant un système de substances au moins binaire.

8. Procédé selon l'une des revendications précédentes, **caractérisé en ce que** l'étape de dépôt d'une deuxième couche (7, 71, 72, 73) comprenant un verre de dépôt en phase vapeur comprend l'étape de co-dépôt de substance organique.

9. Procédé selon l'une des revendications précédentes, **caractérisé en ce que** l'étape de fabrication d'un premier revêtement (3, 31, 32) négativement structuré comprend l'étape de vernissage, en particulier de vernissage par centrifugation et/ou pulvérisation et/ou électrodéposition d'un premier revêtement (3, 31, 32).

10. Procédé selon l'une des revendications précédentes, **caractérisé en ce que** l'étape de fabrication d'un premier revêtement (3, 31, 32) négativement structuré comprend l'étape d'impression d'un premier revêtement (3, 31, 32).

11. Procédé selon l'une des revendications précédentes, **caractérisé en ce que** l'étape de fabrication d'un premier revêtement (3, 31, 32) négativement structuré comprend l'étape d'application d'une feuille de photorésist.

12. Procédé selon l'une des revendications précédentes, **caractérisé en ce que** l'étape de fabrication d'un premier revêtement (3, 31, 32) négativement structuré comprend l'étape d'impression structurée d'un premier revêtement (3, 31, 32), en particulier d'impression structurée par sérigraphie.

13. Procédé selon l'une des revendications précédentes, **caractérisé en ce que** l'étape de fabrication d'un premier revêtement (3, 31, 32) négativement structuré comprend l'étape de structuration lithographique du premier revêtement (3, 31, 32) et/ou l'étape de structuration lithographique avec degrés de gris.

14. Procédé selon l'une des revendications précédentes, **caractérisé en ce que** l'étape de fabrication d'un premier revêtement (3, 31, 32) négativement structuré sur l'au moins une surface (2) comprend l'étape d'application d'une couche (3, 31, 32) photostructurable.

15. Procédé selon la revendication 14, **caractérisé en ce que** l'étape d'application d'une couche (3, 31, 32) photostructurable comprend l'étape d'application d'une laque photosensible.

16. Procédé selon l'une des revendications précédentes, **caractérisé en ce que** l'étape de retrait au moins partiel du premier revêtement (3, 31, 32) comprend l'étape de dissolution du revêtement (3, 31, 32) dans un solvant.

17. Procédé selon l'une des revendications précédentes, **caractérisé en ce que** l'étape de retrait au moins partiel du premier revêtement (3, 31, 32) comprend l'étape de retrait du revêtement par voie chimique humide.

18. Procédé selon l'une des revendications précédentes, **caractérisé en ce que** l'étape de retrait au moins partiel du premier revêtement (3, 31, 32) comprend l'étape de retrait du revêtement (3, 31, 32) par voie chimique sèche, en particulier l'étape de combustion du premier revêtement dans un plasma oxydant.

19. Procédé selon l'une des revendications précédentes, **caractérisé en ce que** l'étape de retrait au moins partiel du premier revêtement (3, 31, 32) comprend l'étape de soulèvement de zones de l'au moins une deuxième couche (7, 71, 72, 73) .

20. Procédé selon l'une des revendications précédentes, **caractérisé par** l'étape de dégagement au moins partiel du premier revêtement (3, 31, 32).

21. Procédé selon la revendication 20, **caractérisé en ce que** l'étape de dégagement au moins partiel du premier revêtement (3, 31, 32) comprend l'étape d'aplanissement de la surface revêtue.

22. Procédé selon la revendication 20 ou 21, **caractérisé en ce que** l'étape de dégagement au moins partiel du premier revêtement (3, 31, 32) comprend l'étape d'enlèvement mécanique, en particulier par meulage et/ou rodage et/ou polissage.

23. Procédé selon l'une des revendications précédentes, **caractérisé par** l'étape de traitement consécutif de la deuxième couche positivement structurée, en particulier par voie chimique humide et/ou voie chimique humide et/ou refusion thermique et/ou dopage.

24. Procédé selon l'une des revendications précédentes, **caractérisé en ce que** les étapes de fabrication d'un premier revêtement (3, 31, 32) négativement structuré sur l'au moins une surface (2) et de dépôt d'au moins une deuxième couche (7, 71, 72, 73) comprenant un verre de dépôt en phase vapeur, sont exécutées plusieurs fois.

25. Procédé selon l'une des revendications précédentes, **caractérisé par** l'étape d'assemblage du substrat (1) avec un autre substrat (25), en particulier un composant semiconducteur et/ou un composant optoélectronique et/ou un composant micro-électromécanique.

26. Procédé selon l'une des revendications précédentes, **caractérisé en ce qu'**au moyen du procédé, au moins un réseau de phase et/ou au moins un composant optique et/ou au moins un canal (40) et/ou au moins un guide d'ondes (93, 94) sont définis dans la deuxième couche (7, 71, 72) comprenant un verre de dépôt en phase vapeur.

27. Procédé selon l'une des revendications précédentes, **caractérisé par** l'étape de comblement au moins partiel de structures de la deuxième couche comprenant un verre de dépôt en phase vapeur, en particulier de comblement avec un matériau conducteur et/ou un matériau transparent (29).

28. Procédé selon l'une des revendications précédentes, **caractérisé par** l'étape d'application d'au moins une zone conductrice, en particulier une piste conductrice (19), sur la surface du substrat et/ou l'au moins une deuxième couche (7, 71, 72, 73).

29. Procédé selon la revendication 27 ou 28, **caractérisé en ce que** l'étape de comblement de structures de la deuxième couche et/ou l'étape d'application d'au moins une zone conductrice comprennent l'étape de fabrication d'au moins un composant électronique passif, en particulier d'un condensateur et/ou d'une résistance et/ou d'une inductance.

30. Procédé selon l'une des revendications précédentes, **caractérisé en ce que** le substrat présente au moins deux surfaces (2, 4) à revêtir, en particulier sensiblement opposées, les étapes :
- de fabrication d'au moins un premier revêtement (3, 31, 32) négativement structuré sur l'au moins une surface (2),
- de dépôt d'au moins une deuxième couche (7, 71, 72, 73) comprenant un verre de dépôt en phase vapeur sur la surface (2) pourvue du premier revêtement (3, 31, 32), et
- de retrait au moins partiel du premier revêtement (3, 31, 32) sur chacune des surfaces (2, 4),
étant exécutées.

31. Procédé selon l'une des revendications précédentes, **caractérisé par** l'étape d'application d'une couche de liaison sur la deuxième couche (7, 71, 72, 73), en particulier d'une couche de liaison comprenant une couche de germe pour une métallisation consécutive et/ou une couche adhésive.
